Europäisches Patentamt

European Patent Office

Office européen des brevets

(19)

(11) **EP 0 939 907 B1**

(12) **EUROPÄISCHE PATENTSCHRIFT**

(45) Veröffentlichungstag und Bekanntmachung des Hinweises auf die Patenterteilung:
**11.12.2002 Patentblatt 2002/50**

(21) Anmeldenummer: **97923854.0**

(22) Anmeldetag: **07.05.1997**

(51) Int Cl.⁷: **G01S 13/02**

(86) Internationale Anmeldenummer:
**PCT/EP97/02339**

(87) Internationale Veröffentlichungsnummer:
**WO 97/042519 (13.11.1997 Gazette 1997/49)**

(54) **VERFAHREN ZUM DURCHFÜHREN EINER BERÜHRUNGSLOSEN FERNABFRAGE**

PROCESS FOR CARRYING OUT A NON-CONTACT REMOTE ENQUIRY

PROCEDE D'EXECUTION D'UNE INTERROGATION A DISTANCE SANS CONTACT

(84) Benannte Vertragsstaaten:
**CH DE FR LI**

(30) Priorität: **07.05.1996 CH 115796**

(43) Veröffentlichungstag der Anmeldung:
**08.09.1999 Patentblatt 1999/36**

(60) Teilanmeldung:
**00105988.0 / 1 035 419**

(73) Patentinhaber: **HERA Rotterdam B.V.**
**3062 MA Rotterdam (NL)**

(72) Erfinder:
• **STIERLIN, Roland**
**CH-5034 Suhr (CH)**
• **KÜNG, Roland**
**CH-8633 Wolfshausen (CH)**

(74) Vertreter: **VOSSIUS & PARTNER**
**Siebertstrasse 4**
**81675 München (DE)**

(56) Entgegenhaltungen:
WO-A-93/13495       GB-A- 2 070 393
US-A- 3 883 831       US-A- 4 734 698
US-A- 4 737 790

• **1995 IEEE ULTRASONICS SYMPOSIUM, Seiten 117-120, XP002040038 PLESSKY ET AL.: "SAW Tags:New Ideas" in der Anmeldung erwähnt**
• **1993 IEEE ULTRASONICS SYMPOSIUM, 31.Oktober 1993, Seiten 125-130, XP000473552 REINDL ET AL.: "Programmable Reflectors for SAW-ID-Tags" in der Anmeldung erwähnt**
• **1994 IEEE INTERNATIONAL FREQUENCY CONTROL SYMPOSIUM, Seiten 337-342, XP000647174 DANICKI: "A SAW Resonator Filter Exploiting RMSCs" in der Anmeldung erwähnt**

**Beschreibung**

Die Erfindung betrifft ein Verfahren zum Durchführen einer berührungslosen Fernabfrage in einem System mit einer Gruppe von mobilen Transpondern, wobei eine Abfragestation ein Abfragesignal aussendet, dieses Abfragesignal in einem der Transponder mit einem SAW-Element in ein informationstragendes Antwortsignal umgewandelt und dann an die Abfragestation 1 zurückgesendet wird.

Weiter betrifft die Erfindung eine Anordnung zur Durchführung des Verfahrens, einen Transponder für eine solche Anordnung, ein SAW Element geeignet für einen Transponder und einen Algorithmus zur Reduktion der Störeinflüsse auf die Laufzeitverzögerung des Antwortsignals.

Verfahren der eingangs genannten Art, die die Identifikation von Transpondern beschreiben, sind z.B. aus den US-Patenten 4,737,790 (Skeie et al./X-Cyte Inc.), 4,734,698 (Nysen et al. X-Cyte Inc.) und 4,096,477 (Epstein et al. Northwestern University) bekannt. Mittels einer Abfragestation werden dabei passive SAW-Transponder (sogenannte SAW-tags) identifiziert. Die Transponder verfügen über ein geeignet verpacktes SAW-Element (SAW = surface acoustic wave) aus piezoelektrischem Material und geeignete Antennen zum Empfangen und Abstrahlen von elektromagnetischen Wellen im Bereich von 905-925 MHz. Das SAW-Element modifiziert das empfangene Abfragesignal und erzeugt eine Vielzahl von Antwortsignalen mit je einer charakteristischen Laufzeit. Für die Codierung des SAW-Elementes werden zwei unterschiedliche Verfahren verwendet. Im Patent 4,095,477 wird ein SAW-Element verwendet, das keine Reflektoren enthält und auf dem durch Verwenden oder Auslassen eines Ausgangstranducers eine binäre Codierung realisiert ist. Das Antwortsignal enthält damit eine unterschiedliche, codespezifische Anzahl Signalkomponenten. Dies bedeutet beispielsweise für einen Code 1000 (binär), daß genau eine, für den Code 1111 (binär) genau 4 Antwortsignalkomponenten vorhanden sind. Als Abfragesignal wird ein kurzer Puls verwendet.

Im Verfahren, das in den Patenten von X-Cyte beschrieben ist, modifiziert das SAW-Element zusätzlich die Phasen der Antwortsignale. Die Anzahl der Antwortsignalkomponenten ist dabei unabhängig vom realisierten Code, was für die Decodierung ein Vorteil ist. Das Abfragesignal ist ein sogenanntes Chirp-Signal, dessen Frequenz sägezahnartig im Bereich von 905-925 MHz variiert. Das SAW-Element verfügt über 16 verschiedene Ausbreitungspfade (akustische Codierkanäle). Damit ergeben sich 16 verschiedene Antwortsignale, deren Signallaufzeiten für alle SAW-Elemente des Systems so festgelegt sind, daß sie sich jeweils um ein vorgegebenes Zeitintervall $\Delta T$ unterscheiden. Die über verschiedene Pfade laufenden Antwortsignale weisen somit eine konstante (d.h. für alle tags gleiche) zeitliche Stufung auf. Beim Mischen des Abfragesignals mit den Antwortsignalen wird in der Abfragestation eine vorgegebene Anzahl von im voraus bekannten Differenzfrequenzen erzeugt.

Die Differenzfrequenzsignale entsprechen den Schwebungen zwischen den Abfrage- und den zeitlich verzögerten Antwortsignalen. Sie werden von entsprechend abgestimmten Filtern verarbeitet. Da in jedem Ausbreitungspfad des SAW-Elements Dämpfungs- bzw. Phasenschiebeelemente entsprechend dem transponderspezifischen Code eingebaut sind, lassen sich aus den Phasen bzw. Amplituden der Differenzfrequenzsignale die transponderspezifischen Codeinformationen gewinnen.

Temperaturänderungen und Herstellungstoleranzen führen zu störenden Laufzeitschwankungen der Antwortsignale. Daraus ergeben sich Phasenschwankungen die eine Decodierung verfälschen, erschweren oder gar unmöglich machen. Für die praktische Anwendung wird daher ein Verfahren zur Kalibrierung angewandt wie es im erwähnten US-Patent 4,734,698 beschrieben wird. Dazu müssen zwei Codierkanäle im Transponder einen einheitlichen, transponderunspezifischen Code tragen. Die Differenz der beiden entsprechenden Antwortsignale dient als Referenz für die genauere Bestimmung der Phaseninformation der anderen Antwortsignale.

Das oben beschriebene oder ähnliche Verfahren weisen eine Reihe von nachstehend aufgeführten Problemen auf. Die verwendete Phasencodierung ist bei einer Frequenz von 2.45 GHz enorm störanfällig, da bereits kleinere Temperaturschwankungen zu großen Phasenänderungen führen. Wird z.B. Lithiumniobat (0,7 %/100°C) als Substratmaterial für das SAW-Element verwendet, so ist bei einer Temperaturänderung von 100°C und einer relativen Laufzeitdifferenz von 100 ns die relative Phasenänderung der entsprechenden Antwortsignale ca. 230° bei 905 MHz und ca. 615° bei 2,45 GHz. Bei 2,45 GHz ergeben sich Probleme mit der Mehrdeutigkeit oder aber die Reflektoren müßten so nahe beieinander sein, daß Probleme mit der Auflösung entstehen und/oder sich Probleme mit der Plazierung von für die Codierung notwendigen Phasenelementen ergeben.

Ein weiteres Problem ergibt sich aus der beschrieben Art der Kalibrierung. Die Verwendung von zwei Antwortsignalen mit einheitlicher, tranponderunspezifischer Codierung reduziert die Anzahl der für die Identifikation verwendbaren Antwortsignale um 2. In der beschrieben Ausführung von X-Cyte wird damit die Anzahl unabhängiger Codes im Vergleich zum selben System ohne Kalibrierung um den Faktor 4x4=16 reduziert.

Ein weiteres Problem ergibt sich aus der Notwendigkeit zur optimalen Trennung von Antwortsignalen und Störsignalen. Die Störsignale entstehen sowohl außerhalb des Transponders (z.B. durch Reflexionen des Abfragesignals an metallischen Gegenständen) als auch innerhalb desselben (z.B. Mehrfachreflexionen zwischen Transducer (Wandler) und Reflektoren in den akustischen Kanälen). Die störenden internen Reflexionen können bekannterweise dadurch wirksam reduziert werden, wenn im Antwortsignal die Komponente mit der längsten Laufzeit mindestens doppelt so lang ist, wie die kürzeste Laufzeit. Diese Bedingung führt aber in der bekannten Ausgestaltung des SAW-Elementes und bei großer Anzahl (z.B. > 6) an Codierkanälen zu SAW-Elementen mit hohem Chip-Flächenbedarf. Ein weiteres Problem ergibt sich aus der Forderung nach kostengünstiger Produktion des SAW-Elementes. Ein für die Stückkosten wichtiger Faktor ist dabei die Fläche des SAW-Elementes. Je kleiner diese ist, desto preiswerter wird der tag. Die bekannten SAW-tags vermögen diesbezüglich nicht zu befriedigen.

Weitere Probleme ergeben sich mit dem in der US-A-4,096,477 ausgeführten Verfahren zur Codierung der SAW-Elemente dadurch, daß die Anzahl der zu verarbeitenden Antwortsignale codespezifisch ist, die internen Störsignale (Mehrfachreflexionen zwischen den Transducern) stark und zahlreich sind und eine hohe Anzahl von Ausgangstransducern benötigt wird (z.B. für $2^{16}$ Codes werden 16 Ausgangstranducer benötigt).

Ein weiteres Problem ergibt sich daraus, die einfallenden Abfragesignale möglichst effizient, d.h. mit minimalen Verlusten in Antwortsignale umzuwandeln. Je besser die Reflektoren die Abfragesignale reflektieren, desto größer ist z.B. die maximal erreichbare Lesedistanz. Dafür geeignete Reflektoren werden z.B. in dem US-Patent 4 737 790 beschrieben. Sie arbeiten auf der Grundfrequenz von ca. 915 MHz. Die Herstellung von Reflektoren auf einer Grundfrequenz von ca. 2,45 GHz ist herstellungstechnisch sehr schwierig, da die Breite der Elektrodenfinger ca. 0,4 µm ist und bringt damit erhebliche Kostennachteile. Die Verwendung von Reflektoren, die auf der 3. Harmonischen arbeiten und eine Breite der Elektrodenfinger von ca. 0,6 µm haben ist aus der Literatur bekannt (z.B. K. Yamanouchi, "2,5 GHz-range SAW propagation....", 1993 IEEE Ultrasonics Symposium). Die genaue Breite der Elektrodenfinger hängt insbesondere ab vom verwendeten Substratmaterial. Die obigen Angaben beziehen sich auf 128°-LiNbO$_3$.

Ein weiteres Problem ergibt sich daraus, auf einer gegebenen Chipfläche die Anzahl möglicher Codes (Kostenreduktion) und gleichzeitig die Stärke der Antwortsignale (lange Lesedistanz oder sichere Auslesung in Umgebung mit starken Störsignalen) zu maximieren.

Eine wirkungsvolle Erhöhung der Antwortsignalstärke wird erreicht, wenn möglichst wenig akustische Kanäle realisiert werden müssen. Wie in der Literatur angegeben (V.P. Plessky, et al., "SAW Tags: New Ideas", 1995 IEEE Ultrasonics Symposium) ergibt sich z.B. ein Zusatzverlust von 12 dB, wenn anstelle eines Transducers mit 2 akustischen Kanälen eine Lösung mit 4 Transducer und 8 akustischen Kanälen realisiert wird.

Um bei wenigen oder gar nur einem akustischen Kanal eine Vielzahl verschiedener Codes zu erzeugen, ist es vorteilhaft, in den gleichen Kanal mehrere Reflektoren zu setzen, wie dies aus der Literatur (z.B. L. Reindl et al. "Programmable reflectors for Saw-ID-tags", 1993 IEEE Ultrasonic Symposium) bekannt ist. Bei mehr als einem Reflektor in einem Kanal entstehen Mehrfachreflexionen zwischen den Reflektoren, die insbesondere bei der Anwendung der beschriebenen Positionscodierung stören können. Der störende Einfluß kann vermindert werden, wenn z.B. die Reflektivität einer Mehrzahl von Reflektoren klein gewählt wird oder die Reflektoren weit auseinander gesetzt werden. Beides führt zu einer Abschwächung der Antwortsignale der entsprechenden Reflektoren, was für das Identifikationssystem nachteilig ist und z.B. die maximale Lesedistanz reduziert.

Aufgabe der Erfindung ist es, ein Verfahren der eingangs genannten Art anzugeben, das eine möglichst einfach realisierbare und wenig störanfällige Identifizierung erlaubt und dabei eine große Codiervielfalt (d.h. einen großen Coderaum) mit guter Nutzung der Chipfläche des SAW Elements zuläßt.

Die erfindungsgemäße Lösung ist durch die Merkmale des Anspruchs 1 definiert. Indem die Positionscodierung mit einer Kalibrierung kombiniert wird, kann insbesondere bei großem Temperaturbereich und bei kleiner Chipfläche die Identifizierung mit hoher Zuverläßigkeit durchgeführt werden. Anstelle einer Kalibrierung kann im Prinzip irgend eine Messung (insbesondere eine Temperaturmessung) treten. Auch der parallele Einsatz von Kalibrier- und Meßsystem ist denkbar.

Die Abfragestation verwendet vorzugsweise ein Chirpsignal zur Abfrage des Transponders. Das Antwortsignal kann als abgetastetes, digitalisiertes Zeitsignal gespeichert und zur Decodierung der identifizierenden. Information einer diskreten Fouriertransformation (FFT) unterworfen werden. Im Frequenzbereich können die Laufzeitunterschiede einfacher detektiert und bearbeitet werden. Zusammen mit der erfindungsgemäßen Realisierung der SAW-Elemente wird eine wirksame Eliminierung von internen Störsignalen und eine kostengünstige Realisierung der Transponder ermöglicht.

Die Codierung führt zu einer charakteristischen, zeitlichen Verzögerung von mindestens einem Teil der Antwortsignalkomponenten. Ein wichtiges Merkmal des Verfahrens ist, daß die Anzahl der identifizierenden Signalkomponenten unabhängig vom implementierten Codewort ist. Sie ist identisch für alle Transponder einer bestimmten Anwendung. Zur Detektion eignet sich die als solche bekannte matched filter-Technik.

Genau eine Antwortsignalkomponente (kalibrierendes Antwortsignal) wird dazu verwendet, die störenden Laufzeitänderungen der Grundverzögerung TO zu messen und die Korrektur der Laufzeiten mindestens der identifizierenden Antwortsignalbestandteile durchzuführen. Ein wichtiges Merkmal des neuen Verfahrens ist, daß die temperaturbedingten relativen Laufzeitschwankungen der identifizierenden Antwortsignale untereinander vernachläßigt werden können.

Die Laufzeiten der identifizierenden Antwortsignale sind so festgelegt, daß jedes Signal in genau einem vorgegebenen Zeitfenster (bezeichnet mit A,B,C, D,...) liegt. Die Summe aller Zeitfenster bildet eine Kette sich nicht überschneidender Zeitintervalle. Jedes Zeitfenster (numeriert mit 0,1,2,3,...) ist wiederum in vordefinierte, dem System bekannte Zeitschlitze unterteilt. Erfindungsgemäß sind die Laufzeiten der identifizierenden Antwortsignale so festgelegt, daß das Signal, respektive der Energieschwerpunkt des Signals, in einen der vordefinierten Zeitschlitze (bezeichnet z.B. mit A0, d.h. im Zeitschlitz 0 von Zeitfenster A) fällt. Die Gesamtheit der besetzten Zeitschlitze bilden ein charakteristisches Muster auf der Zeitachse (bzw. im Spektrum), das der auszulesenden Codenummer entspricht.

Die Größe der verwendeten Zeitschlitze richtet sich nach der Bandbreite des Systems, insbesondere des Abfragesignals. In einer bevorzugten Ausführung ist die Bandbreite des Systems 40 MHz und die Größe der Zeitschlitze mindestens 25 ns. Die Anzahl der Zeitfenster $N_{ZF}$ (z.B. 8) ist bestimmt durch die Anzahl der Codierkanäle respektive der identifizierenden Antwortsignale. Wird die Anzahl der Zeitschlitze pro Zeitfenster mit $N_{ZS}$ (z.B. 4) angegeben, so ergibt sich die folgende Anzahl N möglicher Codes:

$$N = N_{ZS}{}^{N_{ZF}}, \text{(z.B. } 4^8 = 2^{16}) \tag{1}$$

Ein wichtiger Verteil der vorliegenden Erfindung ist es, daß mit wenigen Transducern und Reflektoren eine große Anzahl von Codes erzeuge werden kann. Bei zwei Codierkanälen mit je einem Reflektor benötigt es insgesamt 1 Transducer und 2 Reflektoren um $2^{16}$ mögliche Codes zu realisieren, wenn jeweils 16 Zeitschlitze für die beiden Zeitfenster vorgesehen werden. Im bekannten Verfahren (vgl. eingangs zitierte Patente der Firma X-Cyte) werden für die gleiche Anzahl Codes 4 Transducer und 8 Reflektoren benötigt.

Für die Kalibrierung wird in einem codierenden oder in einem separaten Kanal eine einheitliche Codierung (Familiencode) für alle Transponder einer Anwendung festgelegt. Damit liegen alle kalibrierenden Antwortsignale einer Anwendung z.B. im gleichen Zeitschlitz des gleichen Zeitfensters. Diese Position ist dem System bekannt und kann von Anwendung zu Anwendung definiert verändert werden, z.B. durch Verschieben des kalibrierenden Antwortsignals in einen anderen Zeitschlitz des gleichen Zeitfensters. Damit werden Familien von Transpondern mit gleicher Codenummer aber unterschiedlichem Familiencode definiert.

Die Bestimmung der Ist-Position der kalibrierenden Antwortsignalkomponente im Spektrum des Antwortsignals erlaubt zusammen mit dem Wissen über die Sollposition, die ungefähre Bestimmung der störenden Änderung der Grundverzögerung TO. Diese Laufzeitschwankungen entstehen durch Temperaturänderungen im Transponder, durch die sich ändernde Luftstrecke zwischen Transponder und Antenne der Abfragestation, durch die variable Länge des Antennenkabels und durch Alterung oder Temperaturänderungen in den elektrischen Leitungen zwischen Antenne und Verarbeitungseinheit der Abfragestation.

Im Unterschied zu der im Stand der Technik bekannten Kalibrierung wird beim erfindungsgemäßen Verfahren genau eine Antwortsignalkomponente zur Kalibrierung verwendet. Diese Antwortsignalkomponente ist vorzugsweise diejenige mit der kürzesten Laufzeit. Durch einen Sperrzeitschlitz vorgegebener Dauer ist sie gegenüber den identifizierenden Antwortsignalkomponenten abgetrennt.

Zur Durchführung der Kalibrierung wird mit Vorteil

- das abgetastete und gespeicherte Antwortsignal (Zeitsignal) mit einer Fensterfunktion gewichtet und anschließend einer diskreten Fouriertransformation unterworfen und
- im resultierenden Spektrum eine Ist-Position der kalibrierenden Antwortsignalkomponente bestimmt und mit einer vorgegebenen Soll-Position verglichen.

Die Soll-Ist-Abweichung führt zu einer Frequenzverschiebung $\Delta\omega$, die zur Kalibrierung des Zeitsignals verwendet werden kann.

- Das Zeitsignal wird mit einer Funktion $f(t) = e^{-j\Delta wt}$ multipliziert, was zur Schiebung des Spektrums in eine dem FFT-Raster angepaßte Position führt und als kalibriertes Zeitsignal gespeichert.
- Das Resultat der Multiplikation wird mit einer geeigneten Fensterfunktion gewichtet und einer neuen diskreten Fouriertransformation unterworfen.
- Im erhaltenen Spektrum werden die Maxima der Stützwerte in einer Vielzahl der oder in allen Frequenzfenstern bestimmt. Anschließend wird geprüft, ob die erhaltenen maximalen Stützwerte einen genügenden Rauschabstand aufweisen. Wenn ja, wird der entsprechende Code bestimmt. Wenn nein, wird die Auswertung abgebrochen.

Um auch bei langen Codes und starken Temperatureinflüssen eine zuverlässige Bestimmung des Codes zu ermöglichen, kann das Antwortsignal in mehrere Blöcke aufgeteilt werden. Diese Blöcke werden sukzessive abgearbeitet, wobei in jedem Block eine temperaturbedingte Laufzeit- bzw. Frequenzverschiebung kompensiert wird und dann die entsprechenden identifizierenden Antwortsignalkomponenten ausgewertet werden.

Um Temperatureinflüsse u. dgl. bei der Bestimmung des in den identifizierenden Anwortsignalkomponenten enthaltenen Codes weiter zu minimieren, kann eine zusätzliche, rein rechnerische Korrektur erfolgen. Dazu wird aus dem Spektrum des kalibrierten Zeitsignals durch Korrelation der Position aller dem kalibrierenden Stützwert genügend nahen Stützwerte mit deren Soll-Positionen eine temperaturbedingte Frequenzverschiebung $\delta\Delta\omega$ bestimmt. ("Genügend nahe" bedeutet, daß die maximal zu erwartenden Störeinflüsse in keinem Fall eine wesentliche Verschiebung der in diesem ersten Block berücksichtigten Stützwerte herbeiführen können.) Anschließend wird das gespeicherte und kalibrierte Zeitsignal mit einer Funktion $f(t) = e^{-j\delta\Delta\omega t}$ multipliziert, mit einer Fensterfunktion geeignet gewichtet und fouriertransformiert. Das resultierende Spektrum wird in dieser Weise sukzessive abgearbeitet, wobei jeweils in einer geeigneten Anzahl von noch nicht decodierten Frequenzfenstern die maximalen Stützwerte bestimmt und daraufhin geprüft werden, ob sie einen genügenden Rauschabstand aufweisen, bevor der dazugehörige Teil des Codes bestimmt wird.

In einer weiteren Ausführungsform der Erfindung wird ein Transponder so realisiert, daß nebst identifizierenden und kalibrierenden auch messende Antwortsignalkomponenten an die Abfragestation übertragen werden. Damit können individuell adressierte und berührungslos ausgelesene Meßsonden realisiert werden. Insbesondere der für die Identifikation störende Effekt der Temperaturabhängigkeit der Signalverzögerung kann gezielt zur Temperaturmessung verwendet werden. Die kalibrierenden Antwortsignale können dabei eine Doppelfunktion übernehmen und dienen der Kalibrierung von identifizierenden und messenden Antwortsignalen.

Zur Durchführung einer solchen Messung werden vom SAW-Element mindestens zwei Antwortsignalkomponenten zur Temperaturmessung am Ort des Transponders erzeugt. Da das SAW-Element (welches in diesem Fall zusätzlich als Sensor dient) über seinen Code identifizierbar ist, können in der Abfragestation seine individuellen Kennwerte abgespeichert sein. Die Abfragestation kann also für eine Vielzahl von solchen Sensorelementen Kennwerte speichern, so daß stets eine vollständige Auswertung der eintreffenden Antwortsignale, möglich ist (z.B. Bestimmung der Absoluttemperatur statt nur der Temperaturändsrung).

In einer weiteren Ausführungsform der Erfindung wird ein Transponder so realisiert, daß die Abfrage- bzw. Antwortsignale im Transponder durch eine - den Codierkanälen vor- bzw. nachgeschaltete - gemeinsame laufzeiterhöhende Signalstrecke geführt wird. Der laufzeiterhöhende Effekt der gemeinsamen Verzögerungstrecke ermöglicht eine gute Trennung der Antwortsignale von Störeinflüssen, insbesondere von störenden Umgebungs-Reflexionen des Abfragesignals. Die zumindest teilweise gemeinsame Verwendung der Verzögerungstrecke erlaubt eine Verringerung der für das SAW-Element erforderlichen Fläche bei gleichbleibender Anzahl möglicher Codes. Man ersetzt also insbesondere die nach dem Stand der Technik in jedem einzelnen Codierkanal eines SAW-Tags vorhandene Verzögerungsstrecke und führt bewußt eine gemeinsame zusätzliche Verzögerungsstrecke ein. Dadurch können die nach- bzw. vorgeschalteten Codierkanäle auf eine minimale Länge gebracht werden, ohne die Gesamtlaufzeit des Abfrage- bzw. Antwortsignals im Transponder zu verkürzen.

In aller Regel werden gemeinsame Verzögerungstrecken und Codierkanäle auf einem einzigen SAW-Chip gebildet. Es ist aber durchaus möglich, für die Verzögerungstrecke einen eigenen SAW-Chip vorzusehen.

Für die identifizierenden Signalkomponenten können andere laufzeiterhöhende Signalstrecken verwendet werden als für die den Kalibrier- und/oder Meßzwecken dienenden Signalkomponenten. Denkbar ist auch, daß nur ein Teil der Codierkanäle an der gemeinsamen Verzögerungstrecke angehängt ist.

Um Chipfläche einzusparen, können der Kalibrier- und ein Codierkanal teilweise überlappen, wobei zur Erzeugung der kalibrierenden oder auch der codierenden Antwortsignalkomponente ein teiltransparenter Reflektor vorgesehen ist.

In einer besonders bevorzugten Ausführungsform werden die Reflektoren so realisiert, daß sie auf der zweiten Harmonischen arbeiten. Die Periode der Reflektorstruktur ist gleich der Wellenlänge $\lambda$ der Arbeitsfrequenz, z.B. 2,45 GHz und die Breite der Elektrodenfinger ist ca. die Hälfte der Periode, z.B. ca. 0,8 $\mu$m bei 2,45 GHz und $128°$-$LiNbO_3$ als Substratmaterial.

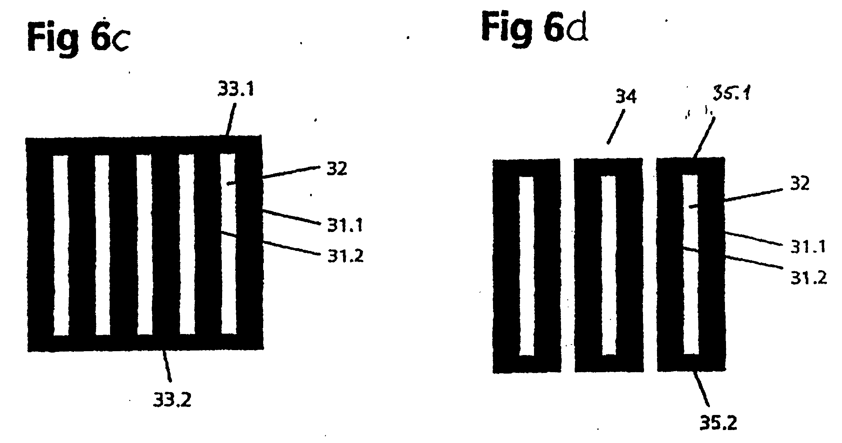

Die Reflektoren funktionieren ähnlich gut für verschiedene Formen der elektrischen Verbindung zwischen den einzelnen Elektrodenfingern. Es eignen sich z.B. alle Finger kurzgeschlossen (Fig. 6c) oder offen, die Finger zu Zweierpaaren verbunden (Fig. 6d) etc. Eine Verbindung kann sowohl an den Enden der Finger oder dazwischen vorhanden sein als auch Kombinationen davon sind möglich.

Die Verwendung der erfindungsgemäßen Reflektoren bringt erhebliche Vorteile im Vergleich zu aus der Literatur bekannten 3. harmonischen Reflektoren:

    1. die Breite der Elektrodenfinger ist größer, ca. 8/5 größer, was die reproduzierbare Herstellung deutlich erleichtert,
    2. der Reflektionskoeffizient der einzelnen Elektrodenfinger ist wesentlich höher,
    3. mit deutlich weniger Elektrodenfinger kann eine hohe Reflektivität erreicht werden, was einen Vorteil für den Platzbedarf auf dem Chip und die Herstellungskosten ist.

Die Verwendung der erfindungsgemäßen Reflektoren bringt auch erhebliche Vorteile im Vergleich zu aus der Literatur bekannten Reflektoren, die auf der Grundfrequenz arbeiten:

1. Bei 128°-LiNbO$_3$ und einer Arbeitsfrequenz von 2,45 GHz ist für die fundamentalen Reflektoren eine Periode (pitch) von ca. 0,8 µm erforderlich und eine Breite der Elektrodenfinger von ca. 0.4 µm. Die kostengünstige Herstellung solcher Strukturen ist schwierig und z.B. außerhalb der Spezifikationen für die heute gebräuchlichen i-line Stepper. In 2. harmonischen Reflektoren verdoppelt sich die erforderliche Periode (pitch) und die Breite der Elektrodenfinger ist jetzt ca. 0,8 µm. 2. harmonische Reflektoren können damit problemlos mit den heutigen i-line Steppern hergestellt werden.

2. Zusätzlich ist bei größerer Periode (pitch) und entsprechend größeren Zwischenräumen die Wahrscheinlichkeit von elektrischen Durchschlägen zwischen den Elektrodenfingern durch statische oder pyroelektrische Aufladungseffekte geringer.

Die vorliegende Erfindung beschreibt einen Reflektor für die Anwendung in einem Transponder, der einfacher herzustellen und/oder höhere Reflektivität aufweist als aus dem Stand der Technik bekannt ist.

Werden Reflektoren in einem akustischen Kanal räumlich hintereinander angeordnet, so entstehen insbesondere störende Mehrfachreflektionen zwischen den Reflektoren.-Ein störender Einfluß ergibt sich insbesondere in Kombination mit der beschrieben Art der Codierung der Transponder mittels Positionscodierung. Dies gilt insbesondere, wenn die Reflektoren aus Platzgründen und um Ausbreitungsverluste zu minimieren nahe beieinander liegen, z.B. näher als 1 mm.

In der Praxis verfügt eine erfindungsgemäße Anordnung über eine Vielzahl von mobilen Transpondern bzw. SAW-tags (je nach Anwendung z. B. mehrere zehn oder mehrere zehntausend). Auch können an mehreren Orten Abfragestationen (entsprechend den jeweiligen Systemanforderungen) vorgesehen sein.

Eine Anordnung zur Durchführung einer erfindungsgemäßen berührungslosen Fernabfrage verfügt über eine Abfragestation zum Aussenden eines Abfragesignals und zum Empfangen und Auswerten eines Antwortsignals, mindestens einen mobilen Transponder mit einer Antenne zum Empfangen des Abfragesignals und/oder Abstrahlen des Antwortsignals und eine Codiereinheit mit mehreren parallelen Codierkanälen zum Umwandeln des Abfragesignals in ein identifizierendes Antwortsignal. Im Sinne der Erfindung ist vor bzw. nach der mindestens einen Codiereinheit eine den entsprechenden Codierkanälen gemeinsame laufzeiterhöhende Signalstrecke angeordnet.

Wenn Verzögerungsstrecke und Codiereinheit auf demselben SAW- Element integriert sind, können die entsprechenden Strukturen durch Transducer (Fingerelektrodenstrukturen), 90°-Reflektoren (z.B. Kopplung von zwei parallelen Kanälen durch zwei aufeinander ausgerichtete 90°-Reflektoren) oder durch RMSC-Strukturen (RMSC = Reversing multistrip coupler) gekoppelt werden. Im Unterschied zu den Ausführungsformen mit Transducern (bei welchen parasitäre Reflexionen des Signals bei -15 bis -20 dB auftreten können) sind die 90°-Reflektoren und die RMSC-Strukturen weitgehend frei von störenden internen Reflexionen.

Es ist nicht zwingend, daß die Antwortsignalkomponenten mit z.B. codespezifisch positionierten Reflektoren erzeugt werden. Es können auch mehrere Codierkanäle mit einseitig abstrahlenden Transducern ausgestattet sein, wobei auf der abstrahlenden Seite empfangende Transducer in codespezifischen Abständen angeordnet sind, welche (über elektrische Leitungen) mit der Antenne verbunden sind.

Weitere bevorzugte Ausführungsformen und Merkmalskombinationen ergeben sich aus der nachfolgenden Detailbeschreibung und der Gesamtheit der Patentansprüche.

Die zur Erläuterung der Ausführungsbeispiele verwendeten Zeichnungen zeigen:

Fig. 1      Eine schematische Darstellung einer Anordnung zur Durchführung einer berührungslosen Fernabfrage;

Fig. 2a, b   Zeitdiagramme zur Erläuterung der Positionscodierung in Kombination mit Kalibrierung und Messung;

Fig. 3      Flußdiagramm der Signalverarbeitung zur Auswertung der Information im Antwortsignal;

Fig. 4      Eine schematische Darstellung eines Transponders mit Meß-, Kalibrier- und Codiereinheit sowie einer gemeinsamen Verzögerungsstrecke und einseitig abstrahlenden Transducern;

Fig. 5      Eine schematische Darstellung einer mit einem SAW-Element realisierten Kalibrier- und Codiereinheit mit teilweiser gemeinsamer Verzögerungsstrekke, Transducerkopplung und einseitig abstrahlenden Transducern in den Codierkanälen;

Fig. 6a     Eine schematische Darstellung einer auf einem SAW-Element realisierten Codiereinheit mit gemeinsamer Verzögerungsstrecke, Kopplung über 90°-Reflektoren und einseitig abstrahlenden Transducern in den Codierkanälen;

Fig. 6b     Eine schematische Darstellung einer auf einem SAW-Element realisierten Codiereinheit mit gemeinsamer Verzögerungsstrecke, Kopplung über RMSC-Strukturen und einseitig abstrahlenden Transducern in den Codierkanälen;

Fig. 6c     Eine bevorzugte Ausführungsform eines 2. harmonishen Reflektors;

Fig. 6d     Eine erfindungsgemäße Ausführungsform eines 2. harmonischen Reflektors.

Grundsätzlich sind in den Zeichnungen gleiche Teile mit gleichen Bezugszeichen versehen.

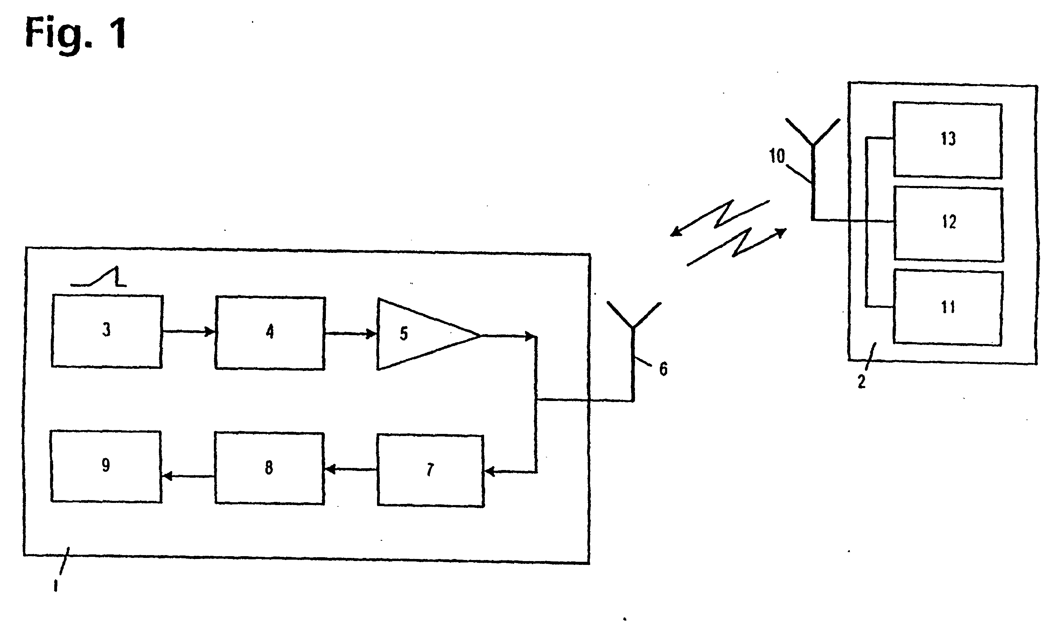

Fig. 1 zeigt ein grobes Blockschaltbild einer Abfragestation 1 und eines Transponders 2. Die Abfragestation 1 sendet ständig Abfragesignale Q (z.B. Chirp-oder Pulssignale) aus und wertet eintreffende Antwortsignale von mobilen, in der Nähe befindlichen Transpondern aus. Beim Transponder 2 handelt es sich um ein passives Element mit einer (vorzugsweise integrierten) Antenne 10, einer Kombination von einer Codier- 11, Kalibrier- 12 und Meßeinheit 13 und elektrischen Leitungen. Er ist z. B. als flaches Plättchen oder als Karte ausgebildet und an dem zu identifizierenden Gegenstand (bzw. am Ort der Messung) als Markierung (Label) angebracht.

Um eine höhere Lesedistanz zu erreichen, ist es im Vergleich zur Aussendung eines kurzen Pulses vorteilhaft, ein an sich bekanntes Chirpsignal (lineare Frequenzrampe) zur Abfrage des Transponders zu benutzen. Ein solches Signal weist eine markant höhere Energie auf, ohne die zulässige Sendeleistung zu überschreiten. Insbesondere ist der Frequenzbereich für die Analyse von Signalen, die einer Summe von cosinusförmigen Antwortsignalen entsprechen, besser geeignet als der Zeitbereich.

Die Abfragestation verfügt über einen Rampengenerator 3, welcher in einer bevorzugten Ausführungsform das Steuersignal für Chirpsignale mit 40 MHz Bandbreite und einer Dauer von $T_{BEOB}$ = 16 ms erzeugt. Die Steilheit der entsprechenden Frequenzrampe beträgt somit 2,5 Hz pro Nanosekunde (Hz/ns). Der Rampengenerator 3 speist einen Trägersignalgenerator 4 (VCO) an, welcher ein frequenzsiabilisiertes Chirpsignal bei der Mittenfrequenz von z.B. 2,44 GHz erzeugt. Das resultierende Abfragesignal wird mit einem Verstärker 5 verstärkt und über eine Antenne 6 abgestrahlt.

Nach Verstreichen einer günstig gewählten Verzögerung $T_0$ treffen die Antwortsignale des Transponders 2 ein. Im Demodulator 7 wird durch Rückmischung des Antwortsignals mit dem Abfragesignal für jede Komponente des Antwortsignals ein niederfrequentes Signal erzeugt, dessen Frequenz exakt proportional (obengenannte 2,5 Hz/ns) zur Laufzeit der entsprechenden Signalkomponente ist. Die charakteristischen Laufzeiten der einzelnen Komponenten des Antwortsignals werden dabei in proportionale Frequenzabstände (bezogen auf eine geeignet gewählte Referenzfrequenz) umgewandelt und lassen sich im Frequenzbereich auswerten.

Damit besteht eine eineindeutige Abbildung zwischen Frequenz- und Zeitbereich, was es erlaubt den Sachverhalt in der einen oder anderen Beschreibung darzustellen. Insbesondere ist es für die Darstellung von Teilen der Erfindung zweckmäßig, eine Beschreibung im Zeitraum zu wählen, wobei die Abfragestation in Gedanken anstelle eines Chirpsignals einen kurzen Impuls aussendet und anstelle eines Antwortssignals mit unterschiedlichen Frequenzkomponenten eine Vielzahl charakteristisch verzögerter Antwortsignale vom Transponder refelektiert werden.

Die niederfrequenten Signale werden zur digitalen Weiterverarbeitung und Decodierung einer Einheit mit A/D-Wandler und DSP 8 zugeführt. Der Code wird z. B. in einem Speicher 9 zwischengespeichert.

Im Transponder 2 wird das über die Antenne 10 empfangene Abfragesignal in eine erfindungsgemäße Kombination einer Codier-, Kalibrier-, und Meßeinheit 11 bzw. 12 bzw. 13 gespeist. Unter Kombination ist dabei zu verstehen, daß auch eine Einheit fehlen kann. Die Funktion der verschiedenen Einheiten wird nachfolgend beispielhaft erläutert. Der Transponder ist dabei insgesamt so gestaltet, daß bis zum Empfang der ersten Signalkomponente $R_A$ ein Zeitintervall $T_0$ verstreicht, das vorzugsweise mindestens halb so groß wie das Zeitintervall $T_1$ (längste Laufzeit einer Antwortsignalkomponente) ist. Auf diese Weise kann das Nutzsignal wirkungsvoll von reflexionsbedingten Umgebungsstörsignalen befreit werden (externe Reflexionen).

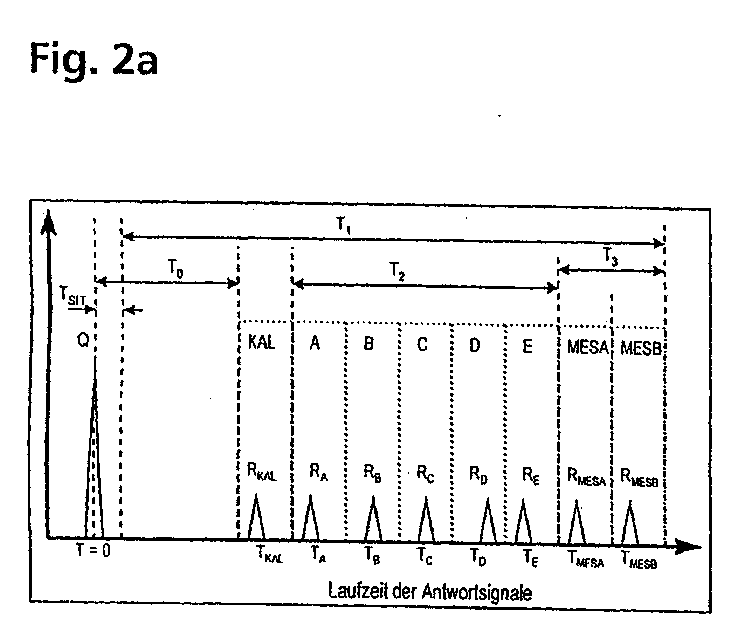

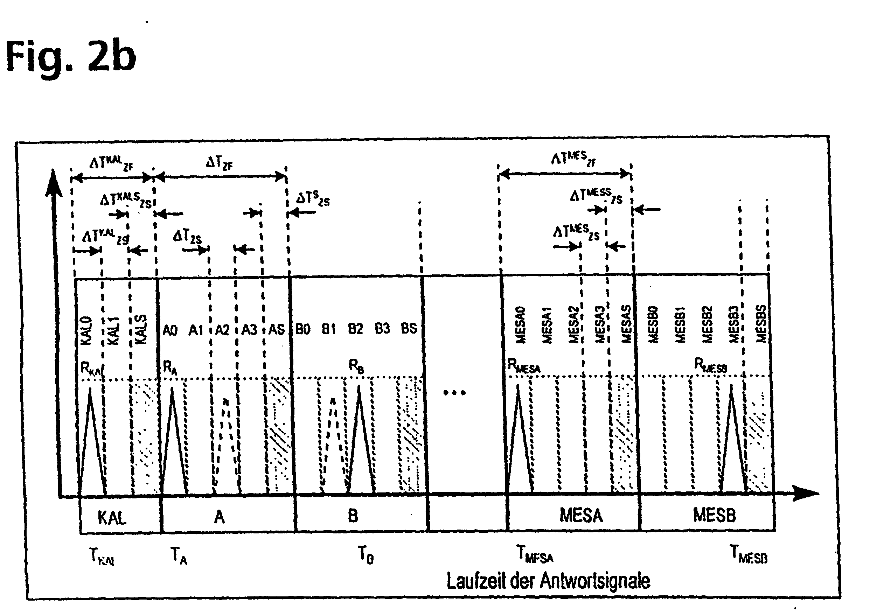

Die Funktion der Codiereinheit 11 und die erfindungsgemäße Signalcodierung sollen beispielhaft an Fig. 2a, b erläutert werden. Fig. 2a zeigt schematisch eine mögliche Signalkonstellation (auf der Abszisse ist die Zeit t aufgetragen). Zum Zeitpunkt t = 0 wird ein z. B. pulsförmiges Abfragesignal Q mit einer Trägerfrequenz von z.B. 2,44 GHz ausgesendet. Die Pulsdauer beträgt z.B. 25 ns. Ein in Reichweite befindlicher Transponder empfängt das Abfragesignal Q und wandelt es in seiner Codiereinheit 11, die eines oder mehre SAW-Elemente enthält, in eine Vielzahl von Antwortsignalen um, mit beispielsweise fünf identifizierenden Signalkomponenten RA, ..., RE.

Das Zeitintervall $T_2 = T_1 - T_0$, dessen Länge für das System (welches in der Regel eine Vielzahl von Transpondern umfaßt) fest vorgegeben ist, ist aufgeteilt in eine Vielzahl von z.B. 5 identifizierenden Zeitfenstern A,B,... Die Länge der Zeitfenster $\Delta T_{ZF}$ ist, z.B. für alle identifizierenden Zeitfenster gleich groß, z.B. 125 ns.

Alle Transponder einer Anwendung sind so ausgeführt, daß in jedes der fünf, identifizierenden Zeitfenster genau eine identifizierende Signalkomponente zu liegen kommt. Erfindungsgemäß ist die Position, d. h. die genaue Laufzeit, einer identifizierenden Signalkomponente innerhalb des entsprechenden Zeitfensters bis auf störenden Laufzeitschwankungen durch die im Transponder realisierte Codierung bestimmt (Positionscodierung).

Fig. 2b veranschaulicht die Decodierung des Antwort Signals. Alle identifizierenden Zeitfenster A, B, ... mit der Länge $\Delta T_{ZF}$ sind in eine vorgegebene Anzahl, von z.B. je 5 Zeitschlitzen A0, A1, ....B0, B1, ... aufgeteilt. Die minimale Länge der Zeitschlitze $\Delta T_{ZS}$ hängt zusammen mit der Bandbreite des Abfragesystems und der daraus ableitbaren noch erzielbaren Auflösung zweier kurzer Signalpulse. In der bevorzugten Ausführung mit einem Chirpsignal von 40 MHz ergibt sich damit eine minimale Länge von 25 ns.

Die identifizierenden Zeitfenster A,B,.... enthalten erfindungsgemäß einen zusätzlichen Sperrzeitschlitz AS,BS,...mit der Länge $\Delta T^S_{ZS}$. Die Codierung erfolgt so, daß kein identifizierendes Antwortsignal in den Sperrzeitschlitz zu liegen kommt. Damit kann der minimal mögliche Zeitabstand zwischen zwei identifizierenden Signalkomponenten in benachbarten Zeitfenstern nach Bedarf eingestellt werden (vgl. auch Fig. 2b). Im vorliegenden Beispiel ist die Länge des Sperrzeitschlitz gleich der Länge der identifizierenden Zeitschlitzen im entsprechen Zeitfenster gewählt. Das erzielbare Signal-zu Geräuschverhältnis wird im Decoder 8 dadurch erhöht.

In einer bevorzugten Ausführung enthalten die identifizierenden Zeitfenster A,B,....E damit 4 identifizierende Zeitschlitze AO,..., A3 bzw. BO, ... B3 etc. und einen Sperrzeitschlitz AS bzw. BS etc. und die Länge aller Zeitschlitze in einem Fenster ist gleich groß, z.B. 25 ns. Daraus ergibt sich eine Länge der Zeitfenster von 5*25 ns=125 ns.

Die Abfragestation muß zur Identifizierung des Transponders die zeitlichen Positionen $T_A$, ..., $T_E$ der identifizierenden Antwortsignale bestimmen und zur Decodierung den vorgegebenen Zeitschlitzen (hier z. B. A0, B2, ..) zuordnen. Das Muster der so besetzten Zeitschlitze aller identifizierenden Zeitfenster bestimmt den transponderspezifischen Code.

In Fig. 2b sind gestrichelt andere mögliche Positionen von Signalkomponenten angedeutet (Zeitschlitze A2, B1,....) wie sie bei einem zweiten Transponder mit anderem Code vorliegen könnten.

Gemäß der Formel 1 können mit fünf Zeitfenstern und je vier identifizierenden Zeitschlitzen $4^5$ = 1024 Codes realisiert werden. In der Praxis wird man nach Bedarf die Zahl der Fenster oder der Zeitschlitze erhöhen (bei zehn Fenstern zu je vier Schlitzen stehen bereits $4^{10} = 2^{20}$, d.h. 20 Bits zur Verfügung).

Es ist nicht erforderlich, daß die Antwortsignalkomponenten ($R_A$,..., $R_E$) vollständig innerhalb eines Zeitschlitzes liegen. Es ist durchaus denkbar, daß sie beidseits aus einem Zeitschlitz herauslappen. Mindestens der "Energieschwerpunkt" muß jedoch hinreichend genau lokalisierbar sein. Das Überlappen reduziert aber das Signalrauschverhältnis und damit die Lesedistanz.

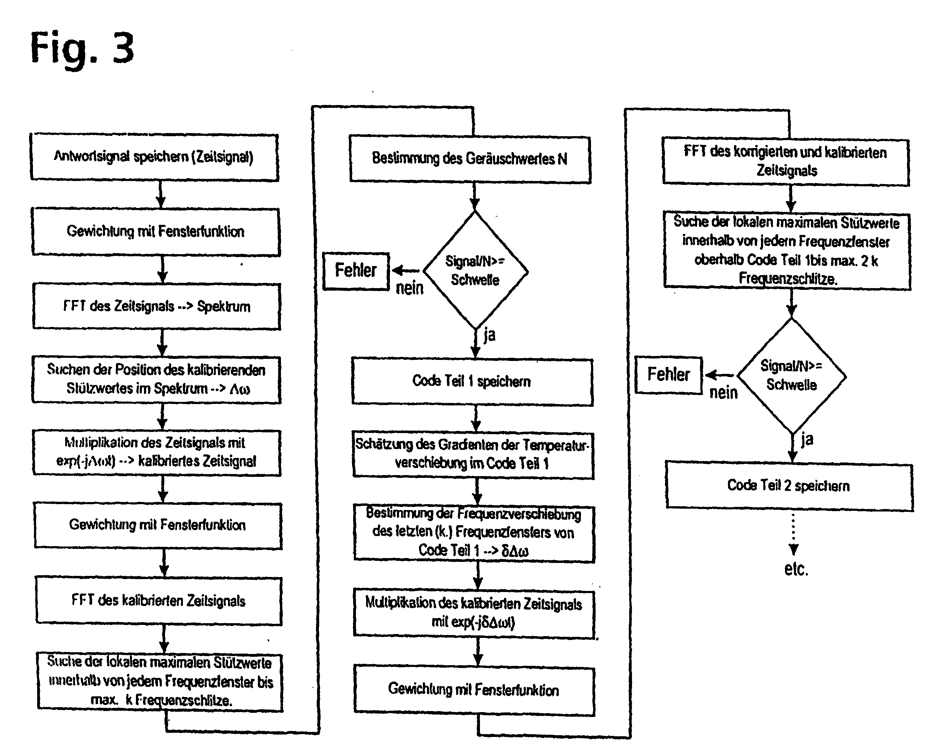

Im folgend wird ein Verfahren zur Decodierung der in den identifizierenden Antwortsignalen enthaltenen Information beschrieben, wie es sich erfindungsgemäß eignet für ein Abfragesystem mit Chirpsignalen. Die einzelnen Verfahrensschritte sind in Fig. 3 aufgeführt.

Die Transformation zur Verarbeitung im Frequenzbereich (Spektrum des Antwortsignals) wird vorteilhaft mittels einer diskreten Fouriertransformation (FFT) unter Nutzung eines digitalen Signalprozessors (DSP) realisiert. Erfindungsgemäß wird die Abtastfrequenz für die Diskretisierung so gewählt, daß die möglichen Antwortsignale exakt mit einem Stützwert der diskreten Fouriertransformation zusammenfallen. Daraus ergibt sich gemäß der bevorzugten Ausführung ein Stützwertabstand von 62,5 Hz (=25 ns x 2,5 Hz/ns). Diese Auflösung im Frequenzbereich entspricht genau der durch die Sendedauer von $T_{BEOB}$ = 16 ms erreichbaren Auflösung von $1/T_{BEOB}$. Die Anzahl der Stützwerte richtet sich nach der Anzahl Zeitschlitze welche der Transponder insgesamt umfaßt. Daraus wiederum läßt sich die Abtastfrequenz bestimmen, die mindestens dem Doppelten der Frequenz des höchsten Stützwertes im relevanten (unter Berücksichtigung der Grundverzögerung $T_0$) Spektrum entspricht. Bei 8 Zeitfenstern ($N_{ZF}$) mit je 5 Zeitschlitzen ($N_{ZS}$) und einer Grundverzögerung $T_0$=1000 ns ergibt sich eine Abtastfrequenz von mindestens 2*(5*8*25 ns+1000 ns)*2,5 Hz/ns = 10 kHz. Prinzipiell ist nun die gesamte in den Antwortsignalen enthaltene Information im Spektrum enthalten, welches völlig analog zum Zeitbereich in Frequenzfenster und Frequenzschlitze eingeteilt ist. Die Decodierung erfolgt nun durch Prüfen, welcher Frequenzschlitz im entsprechenden Frequenzfenster durch ein Antwortsignal besetzt ist.

Zum besseren Verständnis wird für die folgenden Ausführungen wieder auf eine Beschreibung im Zeitbereich gewechselt.

Enthält ein Transponder eine Codiereinheit ohne Kalibriereinheit, so ergeben sich in der praktischen Anwendung erhebliche Probleme. Insbesondere wird der Anwendungsbereich des Systems stark eingeschränkt. Die zur Identifikation notwendige Messung der Laufzeiten TA, TB,..., TE muß so genau erfolgen, daß eine eindeutige Zuordnung zu einem Zeitschlitz möglich ist. Diese ist sicher möglich, wenn die Genauigkeit der Laufzeitmessung mindestens der halben Länge der identifizierenden Zeitschlitze entspricht, z.B. 12,5 ns.

Die Laufzeit der identifizierenden Antwortsignale wird pauschal (für alle gleich) verändert durch:

1. Änderungen in der Länge der Luftstrecke (Lesedistanz),
2. Änderungen der Länge der Antennenzuleitung,
3. Änderungen der Laufzeit in der Abfragestation durch z.B. Alterung oder Temperaturänderung von elektronischen Komponenten,
4. Temperaturbedingte Änderung der im Transponder für alle Antwortsignale gleichen Verzögerung $T_0$-$T_{SIT}$ ($T_{SIT}$ ist der außerhalb des Transponders liegende, meist variable Teil der Grundverzögerung $T_0$),

um einige wichtige pauschale Störeinflüsse zu nennen. So führen, z.B. zusätzliche 2 Meter Antennenkabel und 3 m Luftstrecke bereits zu einer Laufzeiterhöhung von 40 ns, wenn man beachtet, daß das Signal zum Tranponder hin und zurück läuft.

Die Laufzeit der Antwortsignale wird zusätzlich individuell (für jedes Antwortsignal verschieden) verändert durch:

1. temperaturabhängige Variation der Laufzeit in den einzelnen akustischen Kanälen der Codiereinheit,
2. Änderungen der Signalgeschwindigkeit in den einzelnen akustischen Kanälen der Codiereinheit,

um einige wichtige individuelle Störeinflüsse zu nennen.

Es wird ein kalibrierendes Antwortsignal $R_{KAL}$ verwendet, das die pauschalen Störeinflüsse auf die Laufzeiten der Antwortsignale mißt. Dazu wird erfindungsgemäß genau ein Antwortsignal erzeugt, dessen Position in einem Zeitschlitz des kalibrierenden Zeitfensters dem Abfragesystem exakt und im voraus bekannt ist. $T_{KAL}$ bezeichnet die Laufzeit des kalibrierenden Antwortsignals.

Im folgenden wird ein Verfahren zur Reduktion der pauschalen Störeinflüsse beschrieben, wie es sich erfindungsgemäß eignet für das oben beschriebene Abfragesystem mit Chirpsignalen. Dazu wird wiederum in eine Beschreibung im Frequenzraum gewechselt.

Als Folge der genannten, insbesondere der pauschalen Störeinflüsse liegt das Spektrum des Antwortsignals nicht mehr wie gewünscht auf dem diskreten Stützwertraster der FFT. Die Verschiebungen können sogar ab einem gewissen Maß zu einer falschen Codelesung führen. Erfindungsgemäß wird daher wie erwähnt ein kalibrierendes Antwortsignal erzeugt, dessen durch den Transponder erzeugte Verzögerung der Abfragestation bekannt und für alle Transponder einer Anwendung gleich ist.

Dieses kalibrierende Zeitfenster kann vorzugsweise als erstes Zeitfenster KAL auf dem Transponder angebracht sein (vgl. Fig. 2a, b). In anderen Ausführungen kann das kalibrierende Zeitfenster aber auch vorteilhaft zwischen den identifizierenden Zeitfenstern oder aber am Ende liegen.

Mit geeigneter Gewichtung der Abtastwerte vor der Transformation (sogenannte FFT-Fenster) kann eine gute Dekorrelation der einzelnen identifizierenden Antworten im Spektrum erreicht werden, wenn ein gewisser Abstand zwischen kalibrierendem Zeitschlitz (KAL0, $\Delta T^{KAL}_{ZS}$) und den nachfolgenden identifizierenden Zeitschlitzen gegeben ist. Dieser Abstand wird durch den kalibrierenden Sperrzeitschlitz (KALS, $\Delta T^{KALS}_{ZS}$) gegeben. Im Spektrum kann nun die exakte Lage des Maximums des kalibrierenden Antwortsignals ermittelt werden. Dabei ist nur die nähere Umgebung der erwarteten Lage zu untersuchen, um eventuelle Störsignale wie z.B. Tripelreflex auszuscheiden. Dies kann mit der bekannten Matched Filter Technik oder Korrelation geschehen, da die Sollposition des kalibrierenden Antwortsignals dem Abfragegerät bekannt ist. Als Resultat ergibt sich ein genauer, vom Stützwertraster unabhängiger Wert für den Frequenzfehler $\Delta \omega$ in Bezug auf die theoretisch, vom Transponder unabhängige, zu erwartende Frequenz des kalibrierenden Antwortsignals.

Durch anschließende Multiplikation (Mischung) des abgetasteten Antwortsignals im Zeitbereich, wobei das Zeitsignal vorzugsweise im Signalprozessor gespeichert bleibt, mit der komplexen Funktion

$$f(t) = e^{-j\Delta\omega t}, \qquad (2)$$

erreicht man eine spektrale Verschiebung des Zeitsignals um den Frequenzfehler $\Delta\omega$. Das nun kalibrierte, komplexe Zeitsignal wird wiederum derselben FFT unterworfen, welche zur Ermittlung des Frequenzfehlers benutzt wurde. Die Spektren aller Antwortsignale liegen nun fast exakt auf den gewünschten Stützwerten der FFT und ein Dekodierungsfehler infolge nicht erfaßter pauschaler Laufzeitverschiebung ist somit ausgeschlossen.

Das Abfragegerät kann im folgenden die spektralen Stützwerte jedes identifizierenden Zeitschlitzes, resp. Frequenzschlitzes, nach seiner Amplitude abfragen. Da durch die Art der verwendeten Positionscodierung jeweils ein Frequenzschlitz pro Frequenzfenster belegt sein muß, entspricht der maximale Stützwert innerhalb eines identifizierenden Frequenzfensters der gesuchten Position des identifizierenden Antwortsignals.

Um für den Fall, daß schwache Empfangssignale vorliegen, Fehler in der Decodierung zu vermeiden, wird im weiteren außerhalb des durch das Antwortsignal belegten Frequenzbereichs, vorzugsweise innerhalb des Bereichs, der der Grundverzögerung $T_0$ entspricht, der Geräuschpegel des in der Abfragestation eintreffenden Gesamtsignals ermittelt. Ist das Verhältnis von detektierten Maxima in den identifizierenden Frequenzschlitzen zum Geräuschpegel zu gering, wird die decodierte Information verworfen.

Das erfindungsgemäß kalibrierte Spektrum zur Auswertung des Antwortsignals korrigiert auch insbesondere die temperaturabhängige Verschiebung der Grundverzögerung $T_0$. Hingegen wird der individuelle Anteil der Laufzeitverschiebung der Antwortsignale nicht korrigiert. Dies läßt sich anhand der Situation, wie sie beispielhaft in Fig 2a, b dargestellt ist, erläutern. Das kalibrierende Zeitfenster (KAL) mit der Länge $\Delta T^{KAL}_{ZF}$ liegt in dieser Ausführung vor den identifizierenden Zeitfenstern. Die Verschiebungen der Grundverzögerung T0 kann in dieser Anordnung korrigiert werden. Hingegen ist für die nachfolgenden identifizierenden Antwortsignale (A,B,..) die Temperatur nach wie vor wirksam. Bei 100° Temperaturveränderung und einem Temperaturkoeffizienten von ca. 70 ppm/°C für Lithiumniobat ergibt dies eine relative Laufzeitverzögerung von 0,7%. Diese Verschiebung beginnt sich nachteilig auf die Decodierung auszuwirken, wenn die Verschiebung aller identifizierenden Zeitfenster (A, B,...) im Zeitintervall $T_2$ die Hälfte einer Zeitschlitzdauer $\Delta T_{ZS}$ erreicht, z.B. 25 ns/2 = 12,5 ns. Es ist ein vorteilhaftes Merkmal der erfindungsgemäßen Positionscodierung, daß sich dieser individuelle Störeinfluß erst nachteilig auszuwirken beginnt, wenn in der bevorzugten Ausführung die Anzahl aller identifizierenden Zeitschlitze größer als z.B. ca 70 wird. In der bevorzugten Ausführung mit jeweils 5 Zeitschlitzen sind damit für einen Temperaturbereich von 100°C maximal ca. 70/5=14 identifizierende Zeitfenster (A,B,...) oder ca. 70*4/5=56 identifzierende Zeitschlitze nutzbar ohne eine weitere Korrektur der Kalibrierung.

Für Transponder mit mehr identifizierenden Zeitschlitzen oder für einen höheren Temperaturbereich kann entweder die Länge der Zeitschlitze verlängert werden, ein zweiter kalibrierender Zeitschlitz eingeführt werden oder mit Hilfe eines Gradientenalgorithmus (Korrektur der Kalibrierung) eine weitere Frequenzkorrektur $\delta\Delta\omega$ ermittelt werden. Dazu wird aus der theoretisch linear zunehmenden Verschiebung der spektralen Schwerpunkte der kalibrierten und korrekt decodierten Antwortsignale (bis und mit z.B. Zeitschlitz K) durch Korrelation mit dem Sollantwortsignal die weitere Frequenzkorrektur $\delta\Delta\omega$ ermittelt. Der Wert $\delta\Delta\omega$ entspricht dabei erfindungsgemäß dem aus der Gradientenverfolgung bestimmten Frequenzfehler, welcher der temperaturbedingten individuellen Laufzeitverschiebung für den letzten bisher ausgewerteten, identifizierenden Zeitschlitz K entspricht.

In gleicher Weise wie bereits beschrieben, wird für die nächste Anzahl Zeitschlitze (I,J,...) des gespeicherten Antwortsignals erneut mittels besagter komplexer Multiplikation (Formel 2) im Zeitbereich das Spektrum des Zeitsignals spektral um den Wert $\delta\Delta\omega$ verschoben und erneut fouriertransformiert. Für besagte nächste Anzahl Zeitschlitze (I,J,...) ist dann die temperaturbedingte Verschiebung wiederum nicht störend. Die entsprechenden identifzierenden Antwortsignale können nun ebenfalls decodiert werden.

Zur weiteren Sicherung der Decodierung kann der temperaturbedingte Gradient in der Verzögerung aufeinanderfolgender Zeitschlitze in besagter zweiter Anzahl Zeitschlitze ermittelt werden und mit dem Frequenzkorrekturwert $\Delta\omega$ der ersten Anzahl verglichen werden. In einer weiteren Ausführung kann die Signalqualität durch Filterung aufeinanderfolgender Detektionsvorgänge (mehrere Chirp von je $T_{BEOB}$=16 ms Dauer) verbessert werden.

Zusammenfassend ergibt sich also z.B. folgender Verfahrensablauf (vgl. Fig. 3):

    a) Speicherung des Antwortsignals als Zeitsignal in der Abfragestation;
    b) Gewichtung mit einer geeigneten Fensterfunktion;
    c) Bestimmung des Spektrums des gewichteten Zeitsignals (diskrete Fouriertransformation) ;
    d) Bestimmen der Position des kalibrierenden Stützwertes im Spektrum (Ermittlung von $\Delta\omega$) ;
    e) Erzeugen eines kalibrierten Zeitsignals durch Multiplikation des abgespeicherten Zeitsignals mit $\exp(-j\Delta\omega t)$ ;
    f) Gewichtung mit einer geeigneten Fensterfunktion;
    g) Berechnung der diskreten Fouriertransformation des kalibrierten Zeitsignals;
    h) Ermitteln der lokal maximalen Stützwerte innerhalb eines jeden Frequenzfensters mit max. k Frequenzschlitzen;
    i) Bestimmung des Geräuschpegels;
    j) Abbrechen der weiteren Auswertung sofern das Verhältnis Signal zu Rauschen unterhalb einer vorgegebenen Schwelle ist;
    k) Codeteil 1 speichern;
    l) Schätzung des Gradienten der temperaturbedingten Verschiebung innerhalb des gewählten Codeteils 1;
    m) Bestimmung der Frequenzverschiebung des letzten (d.h. k-ten) Frequenzfensters vom Codeteil 1, d.h. des Wertes $\delta\Delta\omega$;
    n) Korrektur des kalibrierten Zeitsignals durch Multiplikation mit $\exp(-j\delta\Delta\omega t)$;
    o) Gewichtung mit einer geeigneten Fensterfunktion;
    p) Bestimmung der diskreten Fouriertransformation des korrigierten kalibrierten Zeitsignals;
    q) Suche des lokal maximalen Stützwertes innerhalb von jedem Frequenzfenster zu den übrigen (höherliegenden) Codeteilen (bis max. 2k Frequenzschlitze);
    r) Erneute Überprüfung des S/N-Verhältnisses;
    s) Zweiten Codeteil speichern;
    t) Sinngemäße Abarbeitung des ganzen Codes.

Nachfolgend wird ein Verfahren zum Bestimmen der in den messenden Antwortsignalen enthaltenen Information beschrieben, wie es sich erfindungsgemäß eignet für ein Abfragesystem mit Chirpsignalen und Transpondern, die zumindest eine Identifizier-Einheit enthalten.

Erfindungsgemäß werden in besagtem Transponder mindestens zwei akustische Kanäle mit je einem Zeitfenster (MESA, MESB) mit der Länge $T_{MESA}$, $T_{MESB}$ für Meßzwecke insbesondere für die Messung der Temperatur des Transponders verwendet. (In Fig. 2a bezeichnet $T_3$ die Laufzeit der messenden Antwortsignale). Es ist dabei vorteilhaft, wenn die beiden Kanäle möglichst stark überlappen, damit die messenden Antwortsignale ($R_{MESA}$, $R_{MESB}$) einen langen, gereinsamen Signalweg aufweisen. Für die Messung der Temperatur eignet sich z.B. die in den Patenten von X-Cyte beschriebene Methode der Messung der Phase der beiden messenden Antwortsignale. Aus der Veränderung der Differenz der beiden Phasen kann die Temperaturveränderung bestimmt werden. Die Ausführung dieser Phasenmessung ist im Prinzip bekannt und in den Patenten von X-Cyte beschrieben.

In einer bevorzugten Ausführung enthalten die messenden Zeitfenster (MESA, MESB) $\Delta T^{MES}_{ZF}$ nur gerade einen Zeitschlitz und einen Sperrzeitschlitz und sind nach den identifizierenden Zeitfenstern angeordnet. Die Länge der entsprechenden Zeitschlitze (MESA0, ..., MESB0,..) $\Delta T^{MES}_{ZS}$ wird so ausgelegt, daß im interessierenden Temperaturbereich keine Winkeldoppeldeutigkeit (mehr als 360°) entsteht und eine hinreichend gute Empfindlichkeit erreicht wird. In einer bevorzugten Ausführung ist die Länge der messenden Zeitschlitze (MESA0, MESB0) und die Länge des entsprechenden Sperrzeitschlitzes (MESAS, MESBS) $\Delta T^{MESS}_{ZS}$ z.B. 25 ns. Bei Lithiumniobat ergibt sich damit, z.B. für 100° Temperaturänderung eine relative Phasenveränderung von ca 306°/100°C oder aber ca. 3°/°C.

Mit obiger Anordnung ist nur die Messung der relativen Temperatur möglich. Die absolute Temperatur kann berechnet werden, da mit der erfindungsgemäßen Kombination von Codier- und Meßeinheit die Möglichkeit besteht, in der Abfragestation Kalibrierinformationen abzuspeichern, die zum jeweiligen Transpondercode gehören.

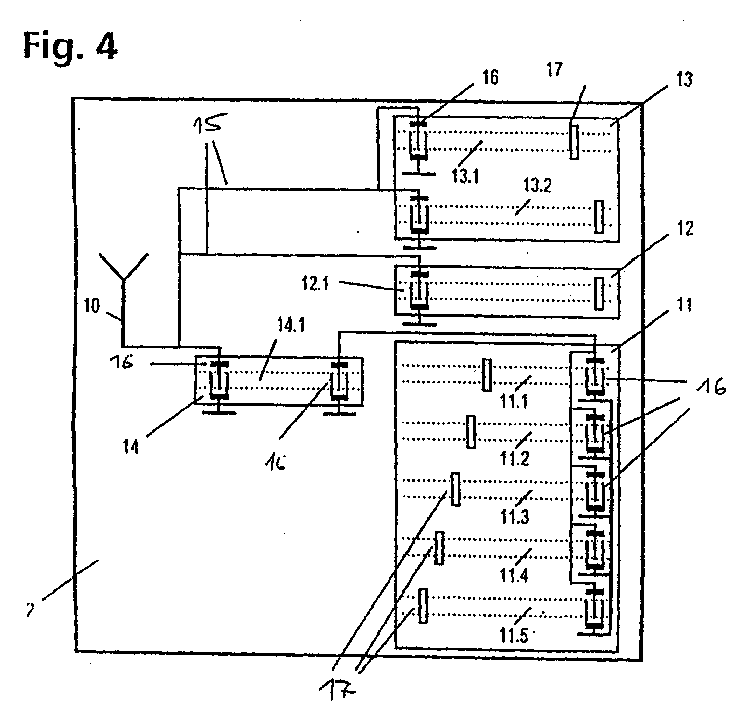

Die Codier- und Kalibriereinheit 11 bzw. 12.1 ist in der bevorzugten Ausführung als ein SAW-Element ausgebildet (vgl. Fig. 4). Die Codiereinheit 11 verfügt im vorliegenden Beispiel über fünf Codierkanäle 11.1 bis 11.5, welche je eine identifizierende Antwortsignalkomponente erzeugen. Die Codierkahäle sind physikalisch als fünf akustische Kanäle verwirklicht. In jedem akustischen Kanal sind je eine Transducerelektrode 16 und ein Reflektor 17 realisiert. Die Reflektoren sind so angeordnet, daß die fünf erwähnten Codierkanäle 11.1, ..., 11.5 mit codespezifischer Länge gebildet werden.

Zwischen Antenne 10 und Codiereinheit 11 ist die ebenfalls auf einem SAW-Slement implementierte Verzögerungstrecke 14. Sie stellt sicher, daß das Antwortsignal die bereits erwähnte Grundverzögerung $T_0$ hat. Die Grundverzögerung $T_0$ wird erfindungsgemäß nicht in den einzelnen Codierkanälen 11.1 bis 11.5, sondern in einem vor- bzw. nachgeschalteten separaten Kanal erzeugt. Wenn nämlich die Grundverzögerung in jedem einzelnen Codierkanal (quasi zusammen mit der Codierung) ausgeführt wird, dann wird insgesamt viel mehr Substratoberfläche benötigt, als bei der erfindungsgemäßen Ausführung. Es ist dabei nicht zwingend, daß die ganze Verzögerung $T_0$ (initial delay) in der getrennten Signalstrecke 14 realisiert ist.

Das von den Antenne 10 empfangene Abfragesignal wird also über eine erste Transducerelektrode 16 in den akustischen Kanal 14.1 eines SAW-Element eingekoppelt, dort um eine Zeit $t_{delay}/2$ ($<= T_0/2$) verzögert, dann über eine zweite Transducerelektrode 16 ausgekoppelt und über eine elektrische Leitung zur Codiereinheit 11 geführt. In dieser wird das Abfragesignal entsprechend der jeweiligen Länge der Codierkanäle reflektiert und verzögert, dann ein zweites Mal in der Signalstrecke 14 um $t_{delay}/2$ verzögert. Die gesamte Signalverzögerung durch die Signalstrecke 12 ist also 2 $t_{delay}/2= t_{delay}$. Um z.B. $t_{delay} = 1$ µs zu erzeugen, wird auf einem 128-$LiNbO_3$-Substrat eine Länge von L = 1990 µm, d.h. etwa 2 mm benötigt. Vorzugsweise ist $t_{delay}$ etwa gleich groß oder geringfügig (z.B. 10 %) größer als $T_2$.

In Fig. 4 ist im Sinne einer Option eine Erweiterung der SAW-Einheit 11 gezeigt, die darin besteht, daß neben der Codiereinheit 11 weitere Kalibrier- 12 und Meßeinheiten 13 mit akustischen Kanälen vorgesehen sind. Diese weiteren Einheiten sind z.B. direkt an der Antenne 10 angeschlossen, können aber auch über die Verzögerungsstrecke 14 geführt werden. Die Kalibriereinheit erzeugt in einem akustischen Kanal, der entsprechend den Codierkanälen aufgebaut und bei allen Transpondern zumindest einer Anwendung gleich ist, das besagte, kalibrierende Antwortsignal ($R_{KAL}$). Durch unterschiedliche Positionierung des Reflektors im Kalibrierkanal kann bei sonst gleicher Codierung eine gruppenspezifische Codierung erzeugt werden, indem die Position des kalibrierenden Antwortsignals als Gruppencode verwendet wird. Die Meßeinheit verfügt z.B. über zwei Kanäle 13.1, 13.2 zur Erzeugung von messenden Antwortsignalkomponenten (welche insbesondere für die Temperaturmessung verwendet werden können).

Den Einheiten 12 und 13 kann z.B. auch eine eigene laufzeiterhöhende Signalstrecke eingeschoben werden. D.h. es können in einem Transponder gewünschtenfalls auch mehrere unterschiedlich lange, gemeinsame Verzögerungsstrecken vorgesehen sein.

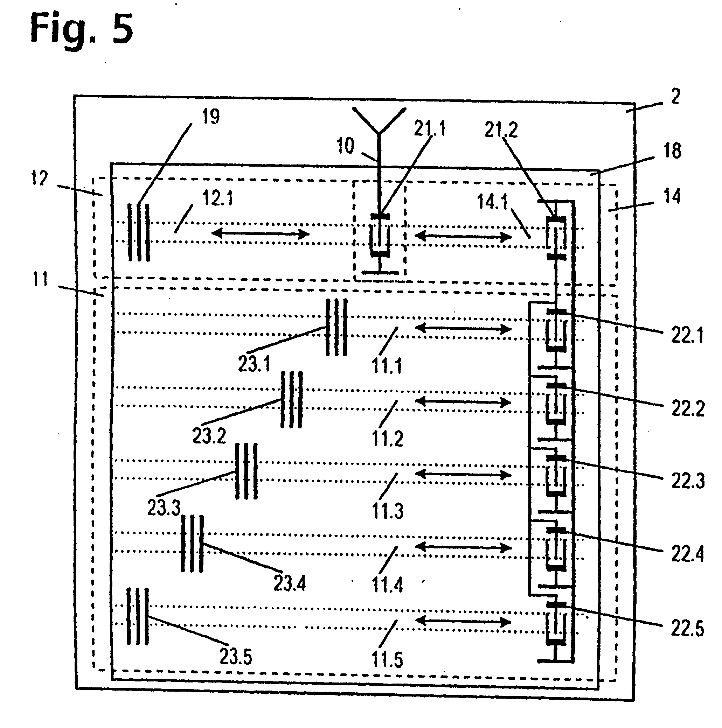

Fig. 5 zeigt eine bevorzugte Ausführungsform der Erfindung, wobei eine Codier- und Kalibriereinheit in einer Anordnung, die Fig 2 entspricht, auf einem einzigen SAW-Chip 18 realisiert ist. Neben den in diesem Beispiel fünf Codierkanälen 11.1 bis 11.5 sind zusätzlich ein Kanal 14.1 als laufzeiterhöhende Signalstrecke und ein Kalibrierkanal 12.1 vorgesehen. Vorzugsweise wird die besagte Verzögerungsstrecke in dieser Ausführung etwas kleiner sein als $T_0/2$ damit der Tripelreflex aus diesem Kanal 14.1 noch vor dem kalibrierenden Antwortsignal aus Kanal 12.1 liegt.

Der Transducer 21.1 strahlt in dieser Ausführungsform in beide Richtungen ab, d.h einerseits zu einem 180°-Reflektor 19 und andererseits zu einem Transducer 21.2. Am Transducer 21.2 sind parallel fünf einseitig abstrahlende Transducer 22.1, ..., 22.5 angeschlossen. Sie strahlen Oberflächenwellen in Richtung der codespezifisch positionierten Reflektoren 23.1, ..., 23.5.

Der Vorteil der geometrischen Anordnung gemäß der bevorzugten Ausführung besteht darin, daß die elektrischen Verbindungsleitungen (busbars) zwischen den auf einer Linie am Rand des Chips liegenden Transducerelektroden 21.2, 22.1 bis 22.5 relativ kurz sind und daher Widerstandsverluste minimiert werden können. Die in Fig. 5 gezeigten Verbindungsleitungen sollen einen kleinen Widerstand im Sinne des folgenden Kriteriums aufweisen:

$$2\pi f * R * C \ll 1, \qquad (3)$$

R bezeichnet den parasitären Leitungswiderstand, C die gesamte statische Kapazität der IDT-Elektrodenstruktur (IDT = interdigital transducer) und f die Arbeitsfrequenz (z.B. f = 2,45 GHz).

In einer weiteren Ausführung der Kombination von Codier- 11, Kalibriereinheit 12 und Verzögerungsstrecke 14 werden erfindungsgmäß die störenden internen Reflexionen an den Transducern 21.2, 22.1 bis 22.5 durch die nachfolgend beschriebenen Maßnahmen (insbesondere 90°-Reflektoren und RMSC-Strukturen) gegenüber den Nutzsignalkomponenten stark (z. B. mehr als -20 dB) reduziert.

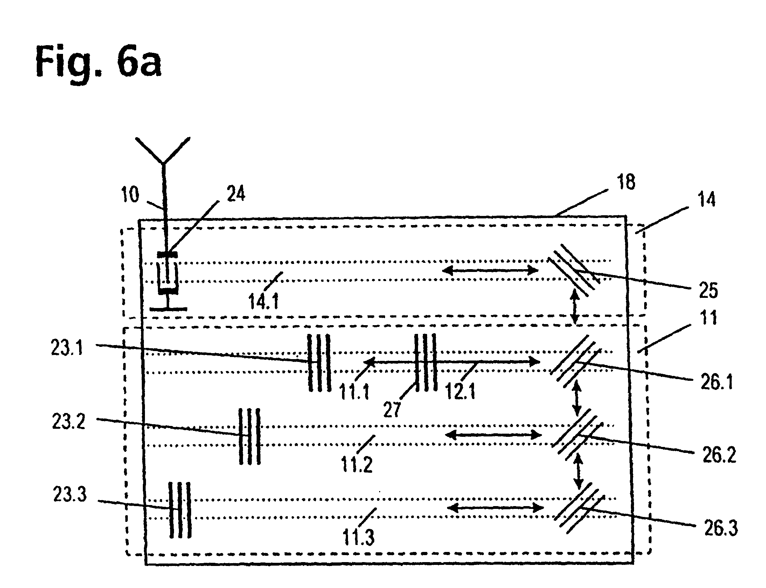

Fig. 6a zeigt eine Variante zu Fig. 5, bei welcher die Kopplung, dargestellt in einer Ausführung mit drei Codierkanälen, zwischen den akustischen Kanälen 14.1, 11.1 bis 11.3 (Fig 6a) nicht mit Hilfe von Transducerelektroden 22.2 und 22.1 bis 22.5 (Fig. 5) sondern mit entsprechend angeordneten 90°-Reflektoren 25, 26.1 bis 26.3 erfolgt. Der in der Darstellung gemäß Fig. 6a zuoberst angeordnete Kanal 14.1 verfügt über einen 90°-Reflektor 25, welcher die Oberflächenwellen aus dem Kanal im 90°-Winkel hinausreflektiert (in der Darstellung gemäß Fig. 6a nach "unten"). Die 90°-Reflektoren 26.1 bis 26.3 sind so auf den 90°-Reflektor 25 ausgerichtet, daß ein Teil der im 90°- Winkel ausgekoppelten Oberflächenwelle in den jeweiligen Kanal 11.1 bis 11.3 eingekoppelt wird. Dort läuft sie zu den Reflektoren 23.1 bis 23.3 (180°-Reflektoren), wird reflektiert und über die 90°-Reflektoren wieder zurück in den Kanal 14.1 gelenkt.

Der Winkel zwischen den schräg verlaufenden Fingerelektroden der 90°-Reflektoren und der kristallografischen x-Koordinate ist nahe bei 45° und hängt von der Anisotropie des benutzten Substrats ab. (Für die - in anderem Zusammenhang an sich bekannte - Bemessung solcher 90°-Reflektoren wird auf das Buch "Surface-wave devices for signal processing", D. Morgan, Elsevier, 1985, verwiesen.)

Es versteht sich, daß zumindest die 90°-Reflektoren 26.1, 26.2 teiltransparent sein müssen.

Eine Variante könnte auch darin bestehen, daß der Codierkanal 11.1. und der Kalibrierkanal 12.1 (Fig 6a) teilweise zur Überlappung gebracht werden, indem in den Codierkanal 11.1 ein zweiter teildurchlässiger Reflektor 27 gebracht wird. Der Reflektor 27 erzeugt in dieser Anordnung ein kalibrierendes Antwortsignal und läßt zugleich einen Teil der einfallenden Oberflächenwelle passieren.

Die Ausführungsform gemäß Fig. 6a hat folgende Vorteile:

1. Die Breite der Elektrodenfinger ist bei schrägen Reflektoren vergrößert, z.B. bei 90° Reflektoren um den Faktor 2 größer als die entsprechende Breite bei 180° Reflektoren (senkrechter Einfall der Welle). Das ist ein wichtiger Vorteil für den 2,45 GHz-Frequenzbereich.

2. Die Widerstandsverluste in den Elektroden sind kleiner, da kein elektrischer Stromfluß von einer Elektrode zur anderen existiert (alle Ströme sind lokal).

3. Es gibt nahezu keine störenden internen Reflexionen, wodurch insbesondere die störenden Dreifachreflexionen (zwischen den Reflektoren und Transducern in Fig. 5) wegfallen.

4. Die Wellenausbreitung quer zur x-Koordinate des Kristalls führt zusätzliche und im Rahmen der Erfindung bevorzugte Signalverzögerungen ein. Entsprechend kann die Chipfläche optimiert bzw. minimiert werden.

Insgesamt zeichnet sich diese Ausführungsform somit durch eine große Flexibilität bei der Dimensionierung, eine heute erleichterte Herstellbarkeit (höhere Ausbeute) und durch erheblich reduzierte interne Störreflexe aus.

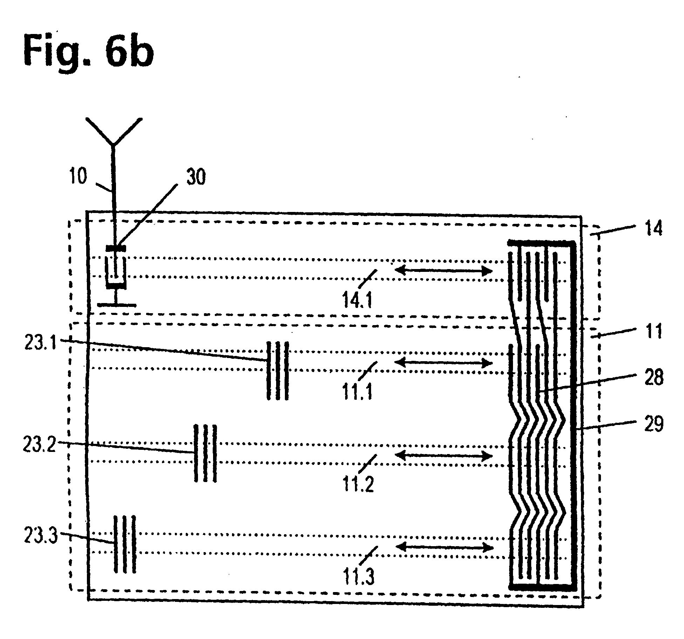

Fig. 6b zeigt eine weitere Möglichkeit, den laufzeitverzögernden Kanal 14.1 mit codierenden oder kalibrierenden Kanälen, beispielsweise drei Codierkanälen 11.1 bis 11.3 zu koppeln. Die Kopplung erfolgt mit einer RMSC-Struktur 28 (Reversing multistrip coupler), wie sie beispielhaft in Fig. 6b dargestellt ist.

Es handelt sich dabei um eine aus anderen Anwendungen bekannte Elektrodenstruktur die in der vorliegenden Ausführung von einer ring- (bzw. C-)förmigen Elektrode 29 (ring ground electrode) umgeben ist, um technologisch aufwendige und damit teure Elektrodenüberkreuzungen vermeiden zu können. Weitere Erläuterungen zu der als solchen bekannten RMSC-Struktur erübrigen sich (vgl. z.B. E. Danicki, "A SAW resonator filter exploiting RMSCs", 1994, Frequency Control Symp. Proc.).

Die RMSC-Struktur kann auf der Grundfrequenz und der zweiten Harmonischen arbeiten. Die Breite der Elektroden bei Betrieb in der Grundfrequenz ergibt sich zu $\lambda/6$ (z. B. $\lambda/6 = 0,26\,\mu m$ bei Grundfrequenz 2,45 GHz). Bei Betrieb in der zweiten Harmonischen ergibt sich eine vorteilhafte Verdoppelung der Elektrodenbreite (z. B. 0,52 μm).

RMSC-Strukturen haben diverse Vorteile für die erfindungsgemäße Realisierung von z.B. Codier- und Kalibrierkanal mit gemeinsamer Verzögerungsstrecke 14 auf einem SAW Chip:

1. Die bekannte elektromechanischen Kopplung der Oberflächenwellen führt dazu, daß eine störenden Rückwärtsreflexion in denselben Kanal sehr schwach ist. Insbesondere können die störenden Reflexionen am Transducer 21.2 und Mehrfachreflexionen in den Codierkanälen 11.1 bis 11.5 (Fig.

5) sehr stark reduziert werden.

2. Weiter ist die Wellenübertragung und Reflexion von einem Kanal in den anderen fast vollständig, wenn die Zahl der Elektrodenfinger hinreichend groß ist, d.h. von der Größenordnung $3 * (\Delta V/V)^{-1}$, wobei $\Delta V/V$ der an sich bekannte Kopplungsfaktor zur Beschreibung der Stärke des Piezoeffektes bei akustischen Oberflächenwellen ist.

Die Ausführungsform gemäß Fig. 6b verwendet also eine RMSC-Struktur. Die Elektrode 29 umgreift alle vier Kanäle 14.1, 11.1 bis 11.3. Die im obersten Kanal 14.1 auf die RMSC-Struktur 28 einfallende Welle wird beispielsweise in die drei Kanäle 11.1 bis 11.3 gekoppelt und mit umgekehrter Ausbreitungsrichtung ausgestrahlt. Sinngemäß werden die codespezifischen Reflexionen aus den Kanälen 11.1 bis 11.3 in den Kanal 14.1 zurückgeführt und dort in entgegengesetzter Richtung ausgestrahlt. Gemäß einer besonders bevorzugten Ausführungsform sind die Elektrodenfinger zwischen den Codierkanälen 11.1 bis 11.3 V-förmig deformiert. Dadurch wird verhindert, daß Oberflächenwellen zwischen den Codierkanälen 11.1 bis 11.3 ausgestrahlt werden. Selbstverständlich können anstelle der V-förmigen auch andere Deformationen vorgesehen sein (zur Verhinderung unerwünschter SAW-Abstrahlung).

Denkbar wäre auch, daß sowohl in Fig. 5 als auch in Fig. 6a und 6b die Reflektoren 23.1 bis 23.3 durch Ausgangstransducer ersetzt werden, so daß das die in den einzelnen Codierkanälen 11.1 bis 11.3 einfallenden Abfragesignale nicht reflektiert und über den Transducer 21.1, respektive 24, respektive 30 zur Antenne 10 geleitet werden, sondern daß die in den Codierkanälen 11.1 bis 11.3 erzeugten Antwortsignale über die erwähnten Ausgangstransducer direkt auf die Antenne 10 geführt werden.

Als Substrat für das SAW-Element wird vorzugsweise $128\text{-}LiNbO_3$ verwendet. Dieses Material zeichnet sich durch starke piezoelektrische Kopplung aus, was wichtig zur Verminderung der Verluste von verhältnismäßig breitbandigen Transducern ist. Weiter hat dieses Material eine hohe Oberflächenwellen-Geschwindigkeit und ein niedriges Niveau parasitärer Bulk-Wellen. Andere Substrate sind jedoch ebenfalls möglich. Für die Ausführungsform mit den 90°-Reflektoren beispielsweise ist $YZ\text{-}LiNbO_3$ von Vorteil wegen den geringen Streuverlusten (diffraction losses).

Die Transducer in allen Ausführungen können als sog. "split electrode transducers" ausgebildet sein, welche auf der dritten Harmonischen arbeiten. In diesem Fall ist die Breite der Elektrode für $128\text{-}LiNbO_3$ etwa 0,6 μm (so auch die Abstände zwischen den Elektrodenfingern). Für sog. "selfmatched" Transducer (d.h. Transducer, bei welchen der imaginäre Teil der Admittanz nahe bei Null ist), benötigt man eine Struktur mit etwa 25 gespaltenen Elektroden (50 Elektrodenfinger). Der Realteil der Admittanz ist nahe bei 50 Ohm, wenn die Apertur nahe bei 100 λ (λ = Wellenlänge der Oberflächenwelle, z. B. 1,6 μm bei 2,45 GHz) ist. Die Dauer der Stoßantwort eines solchen Transducers ist etwa 15 ns.

Die Reflektoren können entweder bei der Grundfrequenz oder bei der dritten Harmonischen arbeiten. Im erstgenannten Fall werden für eine starke Totalreflexion etwa 40 bis 50 Elektrodenfinger gebraucht. Dies bedeutet eine Zeitverzögerung innerhalb der Reflektoren von etwa 16 ns. Da die herstellungstechnischen Anforderungen an Elektroden mit einer Breite von 0,4 μm hoch sind, werden oft gespaltene Elektrodenfinger (split electrodes) verwendet, welche bei der dritten Harmonischen arbeiten und deren Breite beträgt ca. 0,6 μm für $LiNbO_3$ bei 2.45 GHz, Die Zahl der gespaltenen Elektroden liegt im Bereich von typischerweise 15 bis 25.

Reflektorstrukturen, die erfindungsgemäß geeignet sind für die Anwendung in Transpondern (siehe Figuren 6c und 6d), sind periodisch (Periode = pitch) und bestehen aus Elektrodenfingern 31, Zwischenräumen 32, und elektrischen Verbindungen zwischen den Fingern und arbeiten auf der 2. Harmonischen. Die Breite w der Finger ist bevorzugt ungefähr gleich der halben Periode, $w=2*\lambda/4$, wobei λ die Wellenlänge bei der Arbeitsfrequenz ν ist, z.B. ν = 2,45 GHz.

In einer bevorzugten Ausführung werden die 2. harmonischen Reflektoren auf $128°\text{-}LiNbO_3$ Substratmaterial realisiert bei einer Metallschichtdicke von ungefähr 800 Angström.

Fig. 6c beschreibt eine bevorzugte Ausführungsform eines 2. harmonischen Reflektors mit sechs Elektrodenfingern und fünf Zwischenräumen 32. Die Anzahl der Elektrodenfinger ist variabel und kann minimal 1 und maximal ca. 50 betragen. Die Breite der Elektrodenfinger z.B. 31.1, ist bevorzugt ungefähr gleich der Breite der Zwischenräume 32. Die Breite w der Elektrodenfinger auf $128°\text{-}LiNbO_3$ ist ca. $w = 2* \lambda/4 = 0,78$ μm, wobei λ die Wellenlänge des SAW-Signals bei der Arbeitsfrequenz von 2,45 GHz ist. Über eine Verbindung am oberen 33.1 und unteren Fingerende 33.2 sind alle Elektrodenfinger elektrisch miteinander verbunden. Die Breite der Verbindung ist bevorzugt ca. 10 μm, sie kann aber auch größer oder noch kleiner gewählt werden. Die bevorzugte Breite des Reflektors, bzw. die Länge der Elektrodenfinger liegt zwischen ungefähr 150 bis 200 μm aber auch andere Werte sind möglich.

Die Reflektivität R (in dB) dieses Reflektors bei der Mittenfrequenz berechnet sich aus R(in dB) = 20* log(tanhyp(N*r)), wobei n die Anzahl der Elektrodenfinger und r der Reflexionskoeffizient des Einzelfingers ist. Im Vergleich zu 3. harmonischen Reflektoren auf $128°\text{-}LiNbO_3$-Substratmaterial, 300 Angstrom Metallschichtdicke und N = 12 Fingern ergibt sich bei 2. harmonischen Reflektoren eine um ca. 6 dB höhere Reflektivität.

Fig. 6d beschreibt eine erfindungsgemäße Ausführungsform eines 2. harmonischen Reflektors, mit einer anderen Art der Verbindung der Elektrodenfinger. Jeweils zwei Finger, z.B. 31.1 und 31.2 werden zu einem Zweierpaar 34 verbunden. Die Breite der Zwischenräume 32 und der Elektrodenfinger ist ungefähr gleich. Die Breite der Verbindung (35.1 und 35.2) ist unkritisch, bevorzugt wird ca. 10 μm, sie kann aber auch größer oder noch kleiner gewählt werden. Weitere Formen der Verbindung der Elektrodenfinger sind möglich.

Die verschiedenen Ausführungsformen können untereinander kombiniert bzw. abgewandelt werden. Die verschiedenen Arten, die akustischen Kanäle zu koppeln, können im Prinzip kombiniert werden. Akustische Kanäle können parallel und seriell geschaltet sein. Die Anordnung der verschiedenen Kanäle ist vorzugsweise im Sinn minimaler Verluste, eines minimalen Flächenbedarfs und minimaler interner Störreflexe gewählt.

**Patentansprüche**

1. Verfahren zum Durchführen einer berührungslosen Fernabfrage in einem System mit einer Gruppe von mobilen Transpondern, wobei eine Abfragestation (1) ein Abfragesignal (Q) aussendet, dieses Abfragesignal in einem der Transponder (2) mit einem SAW-Element (18) in ein informationstragendes Antwortsignal umgewandelt und dann an die Abfragestation (1) zurückgesendet wird, **dadurch gekennzeichnet, daß** das SAW-Element

   a) zur Erzielung einer Positionscodierung eine vorgegebene Anzahl identifizierender Antwortsignalkomponenten mit codespezifischer Laufzeitverzögerung (bzw. Frequenzverschiebungen) so erzeugt, daß in jedem von $N_{ZF}$ Zeitfenstern (bzw. Frequenzfenstern) genau einer von $N_{ZS}$ Zeitschlitzen (bzw. Frequenzschlitzen) eine Antwortsignalkomponente enthält, und
   b) zur Durchführung einer Kalibrierung oder Messung dem Antwortsignal eine Antwortsignalkomponente mit fest vorgegebener Position innerhalb eines im voraus definierten Zeitfensters (bzw. Frequenzfensters) beifügt.

2. Verfahren nach Anspruch 1, wobei das SAW-Element genau eine Antwortsignalkomponente zur Kalibrierung erzeugt, und wobei diese Antwortsignalkomponente vorzugsweise diejenige mit der kürzesten Laufzeit ist und durch einen Sperrzeitschlitz vorgegebener Dauer gegenüber den identifizierenden Antwortsignalkomponenten abgetrennt ist.

3. Verfahren nach einem der Ansprüche 1 bis 2, wobei

   a) die Abfragestation ein Chirpsignal zur Abfrage des Transponders benutzt,
   b) das Antwortsignal als abgetastetes, digitalisiertes Zeitsignal gespeichert wird und
   c) zur Decodierung der identifizierenden Information das gespeicherte Zeitsignal einer diskreten Fouriertransformation (FFT) unterworfen wird.

4. Verfahren nach einem der Ansprüche 1 bis 3, wobei zur Durchführung der Kalibrierung

   a) das Antwortsignal mit einer Fensterfunktion gewichtet und anschließend einer diskreten Fouriertransformation unterworfen wird und
   b) im resultierenden Spektrum eine Ist-Position der kalibrierenden Antwortsignalkomponente bestimmt und mit einer vorgegebenen Soll-Position verglichen wird.

5. Verfahren nach Anspruch 4, wobei

   a) das gespeicherte Antwortsignal mit einer Funktion $f(t) = e^{-j\Delta\omega t}$ multipliziert und als kalibriertes Zeitsignal gespeichert wird, wobei $\Delta\omega$ eine aus dem Vergleich von Ist- und Soll-Position der kalibrierenden Antwortsignalkomponente bestimmte Frequenzverschiebung ist,
   b) das Resultat der Multiplikation mit einer geeigneten Fensterfunktion gewichtet und einer diskreten Fouriertransformation unterworfen wird,
   c) im erhaltenen Spektrum die Maxima der Stützwerte zumindest in mehreren oder in allen Frequenzfenstern bestimmt werden und anschließend geprüft wird, ob die erhaltenen maximalen Stützwerte einen genügenden Rauschabstand aufweisen, bevor der entsprechende Code bestimmt wird.

6. Verfahren nach einem der Ansprüche 1 bis 5, wobei die identifizierenden Antwortsignalkomponenten blockweise sukzessiv ausgewertet werden, wobei eine temperaturbedingte Laufzeit- bzw. Frequenzverschiebung blockweise kompensiert wird.

7. Verfahren nach Anspruch 6, wobei

   a) vor der 3estimmung des in den identifizierenden Antwortsignalkomponenten enthaltenen Codes in einer Vielzahl von Frequenzfenstern eine zusätzliche, rein rechnerische Korrektur erfolgt, wobei aus dem Spektrum des kalibrierten Zeitsignals durch Korrelation der Position aller dem kalibrierenden Stützwert genügend nahen Stützwerte mit deren Sollpositionen eine temperaturbedingte Frequenzverschiebung $\delta\Delta\omega$ bestimmt wird,
   b) anschließend das gespeicherte und kalibrierte Zeitsignal mit einer Funktion $f(t) = e^{-j\delta\Delta\omega t}$ multipliziert, mit einer Fensterfunktion geeignet gewichtst und fouriertransformiert wird,
   c) im resultierenden Spektrum in den noch nicht decodierten Frequenzfenstern die maximalen Stützwerte bestimmt werden,

d) die besagten Stützwerte geprüft werden, ob sie einen genügenden Rauschabstand aufweisen, bevor der dazugehörige Teil des Codes bestimmt wird.

8. Verfahren nach einem der Ansprüche 1 bis 7, wobei vom SAW-Element mindestens zwei Antwortsignalkomponenten zur Temperaturmessung am Ort des Transponders (2) erzeugt werden und in der Abfragestation entsprechende Kennwerte des über seinen Code identifizierbaren Transponders abgespeichert sind.

9. Verfahren nach Anspruch 8, wobei zur Messung der Temperatur eine relative Laufzeit- oder Phasenveränderung von mindestens zwei messenden Antwortsignalkomponenten bestimmt wird und zusätzlich mit einem in der Abfragestation gespeicherten, transponderspezifischen Kenn- bzw. Kalibrierwert anschließend die Temperatur am Ort des Transponders ermittelt wird.

10. System zur Durchführung des Verfahrens nach einem der Ansprüche 1 bis 9 mit

   a) mindestens einer Abfragestation (1) zum Aussenden eines Abfragesignals (Q) und Auswerten von Antwortsignalen,
   b) einer Gruppe von mobilen Transpondern mit je mindestens einem SAW-Element (18) zum Umwandeln des Abfragesignals in ein informationstragendes Antwortsignal, **dadurch gekennzeichnet, daß** das SAW-Element

   b1) zur Erzielung einer Positionscodierung so ausgebildet ist, daß eine vorgegebene Anzahl identifizierender Antwortsignalkomponenten mit codespezifischen Laufzeitverzögerungen (bzw. Frequenzverschiebungen) so erzeugt wird, daß in jedem von $N_{ZF}$ Zeitfenstern (bzw. Frequenzfenstern) genau einer von $N_{ZS}$ Zeitschlitzen (bzw. Frequenzschlitzen) eine Antwortsignalkomponente enthält, und
   b2) zur Durchführung einer Kalibrierung einen Kalibrierkanal und/oder zur Messung mindestens zwei Meßkanäle derart aufweist, daß dem Antwortsignal eine Antwortsignalkomponente mit fest vorgegebener Position innerhalb eines im voraus definierten Zeitfensters (bzw. Frequenzfensters) beigefügt werden kann.

11. Transponder zur Durchführung des Verfahrens nach einem der Ansprüche 1 bis 9, **gekennzeichnet durch** ein SAW-Element, das

a) zur Erzielung einer Positionscodierung eine vorgegebene Anzahl identifizierender Antwortsignalkomponenten mit codespezifischer Laufzeitverzögerung (bzw. Frequenzverschiebungen) so erzeugt, daß in jedem von $N_{ZF}$ Zeitfenstern (bzw. Frequenzfenstern) genau einer von $N_{ZS}$ Zeitschlitzen (bzw. Frequenzschlitzen) eine Antwortsignalkomponente enthält, und
b) zur Durchführung einer Kalibrierung oder Messung dem Antwortsignal eine Antwortsignalkomponente mit fest vorgegebener Position innerhalb eines im voraus definierten Zeitfensters (bzw. Frequenzfensters) beifügt, und das neben mindestens einer Codiereinheit zur Erzielung einer Positionscodierung auch eine Kalibrier- oder Meßeinheit zur Durchführung einer Kalibrierung bzw. Messung enthält, so daß kalibrierende oder messende Antwortsignalkomponenten erzeugt werden können.

12. Transponder nach Anspruch 11, ferner mit einer Kalibriereinheit (12) zur Erzeugung genau eines kalibrierenden Antwortsignals, das insbesondere dazu verwendet wird, pauschale Störeinflüsse, nämlich Schwankungen der Grundverzögerung $T_0$ zu korrigieren.

13. SAW-Element für einen Transponder nach Anspruch 11 oder 12, **dadurch gekennzeichnet, daß** es

   a) zur Erzielung einer Positionscodierung eine vorgegebene Anzahl identifizierender Antwortsignalkomponenten mit codespezifischer Laufzeitverzögerung (bzw. Frequenzverschiebungen) so erzeugt, daß in jedem von $N_{ZF}$ Zeitfenstern (bzw. Frequenzfenstem) genau einer von $N_{ZS}$.Zeitschlitzen (bzw. Frequenzschlitzen) eine Antwortsignalkomponente enthält, und
   b) zur Durchführung einer Kalibrierung oder Messung dem Antwortsignal eine Antwortsignalkomponente mit fest vorgegebener Position innerhalb eines im voraus definierten Zeitfensters (bzw. Frequenzfensters) beifügt, und das eine Codiereinheit mit mehreren parallelen Codierkanälen zur Erzielung einer Positionscodierung und einen Kalibrier- und/oder Meßkanal zur Durchführung einer Kalibrierung bzw. Messung aufweist.

14. SAW-Element nach Anspruch 13, wobei eine separate, mehreren Codierkanälen gemeinsame laufzeiterhöhende Verzögerungsstrecke vorgesehen ist, welche mit den genannten Codierkanälen und wahlweise mit dem Kalibrierkanal gekoppelt ist.

15. SAW-Element nach Anspruch 14, wobei die akustischen Kanäle durch Transducerelektroden, 90°-Reflektoren oder eine RMSC-Struktur gekoppelt sind.

16. SAW- Element nach einem der Ansprüche 13 bis 15, wobei der Kalibrierkanal mit einem Codierkanal teilweise überlappt, wobei zur Erzeugung der z.B. zeitlich weniger verzögerten kalibrierenden Antwortsignalkomponente ein teiltransparenter Reflektor vorgesehen ist.

17. SAW Element nach einem der Ansprüche 13 bis 16, wobei mehrere Codierkanäle mit beidseitig abstrahlenden Transducern ausgestattet sind und beidseits der genannten Transducer Reflektoren in codespezifischen Abständen angeordnet sind.

18. SAW-Element nach einem der Ansprüche 13 bis 17, wobei mehrere Codierkanäle mit einseitig abstrahlenden Transducern ausgestattet sind und auf der abstrahlenden Seite Transducer in codespezifischen Abständen angeordnet sind.

**Claims**

1. Process for carrying out a non-contact remote interrogation in a system comprising a group of mobile transponders, wherein an interrogation station (1) emits an interrogation signal (Q), said interrogation signal is converted into an information-carrying response signal in a transponder (2) comprising - an SAW element (18) and then returned to the interrogation station (1), **characterized in that** the SAW element

   a) generates a predetermined number of identifying response signal components with code-specific propagation delay (or frequency shifts) for a position encoding such that in any one of $NZ_F$ time windows (or frequency windows) exactly one of $N_{ZF}$ time slots (or frequency slots) contains one response signal component, and
   b) adds a response signal component with predetermined position within one predefined time window (or frequency window) to the response signal for performing a calibration or measurement.

2. Process according to claim 1, wherein the SAW element generates exactly one response signal component for calibration, and wherein this response signal component is preferably that component having the shortest propagation and being separated vis-à-vis the identifying response signal components by an off-time slot having a predetermined duration.

3. Process according to any one of claims 1 to 2, wherein

   a) the interrogation station uses a chirp signal for interrogating the transponder,
   b) the response signal is stored as a sampled, digitized time signal and
   c) the stored time signal undergoes a discrete Fourier transformation (FFT) for decoding the identifying information.

4. Process according to any one of claims 1 to 3, wherein for calibration

   a) the response signal is weighted with a window function and subsequently undergoes a discrete Fourier transformation and
   b) an actual position of the calibrating response signal component is determined in the resulting spectrum and compared with a predetermined desired position.

5. Process according to claim 4, wherein

   a) the stored response signal is multiplied by a function $f(t)=e^{-j\Delta\omega t}$ and stored as a calibrated time signal, wherein $\Delta\omega$ is a frequency shift determined by the comparison of the actual and desired positions of the calibrating response signal component,
   b) the result of the multiplication is weighted with a suitable window function and undergoes a discrete Fourier transformation,
   c) in the received spectrum the maxima of the samples are determined in at least a plurality of or in all frequency windows and it is subsequently tested whether the received maximum samples have a sufficient signal-to-noise ratio, before the corresponding code is determined.

6. Process according to any one of claims 1 to 5, wherein the identifying response signal components are successively evaluated as a block, wherein a temperature-dependent propagation shift or frequency shift is compensated as a block.

7. Process according to claim 6, wherein

   a) prior to the determination of the code contained in the identifying response signal components an additional, merely calculated correction takes place in a plurality of frequency windows, wherein a temperature-dependent frequency shift $\delta\Delta\omega$ is determined from the spectrum of the calibrated time signal by correlation of the position of all samples being sufficiently close to the calibrated sample with their desired positions,
   b) the stored and calibrated time signal is subsequently multiplied by a function $f(t) = e^{-j\delta\Delta\omega t}$, appropriately weighted with a window function and Fourier transformed,

c) the maximum samples are determined in the not yet decoded frequency windows of the resulting spectrum,

d) said samples are tested as to whether they have a sufficient signal-to-noise ratio, before the corresponding part of the code is determined.

8. Process according to any one of claims 1 to 7, wherein the SAW element generates at least two response signal components for temperature measurement at the place of the transponder (2) and corresponding characteristic values of the transponder, which can be identified via its code, are stored in the interrogation station.

9. Process according to claim 8, wherein a relative propagation change or phase change of at least two measuring response signal components is determined for temperature measurement and subsequently the temperature at the place of the transponder is additionally determined with a transponder-specific characteristic value or calibrating value stored in the interrogation station.

10. System for carrying out the process according to any one of claims 1 to 9 comprising

   a) at least one interrogation station (1) for emitting an interrogation signal (Q) and evaluating response signals,
   b) a group of mobile transponders each comprising at least one SAW element (18) for converting the interrogation signal in an information-carrying response signal, **characterized in that** the SAW element

   b1) is, for achieving a position encoding, formed such that a predetermined number of identifying response signal components with code-specific propagation delays (or frequency shifts) is generated such that in any one of $N_{ZF}$ time windows (or frequency windows) exactly one of $N_{ZS}$ time slots (or frequency slots) contains one response signal component, and
   b2) comprises a calibration channel for performing a calibration and/or at least two measuring channels for measurement such that a response signal component with a predetermined position in a predefined time window (or frequency window) can be added to the response signal.

11. Transponder for carrying out the process according to any one of claims 1 to 9, **characterized by** an SAW element which

   a) for achieving a position encoding, generates a predetermined number of identifying response signal components with code-specific propagation delay (or frequency shifts) such that in any one of $N_{ZF}$ time windows (or frequency windows) exactly one of $N_{ZS}$ time slots (or frequency slots) contains a response signal component, and
   b) for performing a calibration or a measurement, adds a response signal component with a predetermined position in a predetermined time window (or frequency window) to the response signal, and which comprises, in addition to at least one encoding unit for achieving a position encoding, also a calibration or measuring unit for carrying out a calibration or measurement so that calibrating or measuring response signal components can be generated.

12. Transponder according to claim 11, further comprising a calibrating unit (12) for generating exactly one calibrating response signal which is used in particular for correcting general disturbing influences, i. e. variations of the basic delay $T_0$.

13. SAW element suitable for a transponder according to claim 11 or 12, **characterized in that**

   a) for achieving a position encoding, it generates a predetermined number of identifying response signal components with code-specific propagation delay (or frequency shifts) such that in any one of $N_{ZF}$ time windows (or frequency windows) exactly one of $N_{ZS}$ time slots (or frequency slots) contains a response signal component, and
   b) for performing a calibration or a measurement, it adds a response signal component with a predetermined position in a predetermined time window (or frequency window) to the response signal, and it comprises an encoding unit with a plurality of parallel encoding channels for achieving a position encoding and a calibration and/or measuring channel for carrying out a calibration or measurement.

14. SAW element according to claim 13, wherein a separate, propagation-increasing delay line which is common to a plurality of encoding channels is provided, said delay line being coupled to said encoding channels and, optionally, to the calibrating channel.

15. SAW element according to claim 14, wherein said acoustic channels are coupled by transducer electrodes, 90°-reflectors or an RMSC structure.

16. SAW element according to any one of claims 13 to 15, wherein the calibrating channel partially overlaps with an encoding channel, wherein a partially transparent reflector is provided for generating, for example, the calibrating response signal component which is less time-delayed.

17. SAW element according to any one of claims 13 to 16, wherein a plurality of encoding channels comprise transducers emitting on both sides and on both sides of said transducers reflectors are provided in code-specific distances.

18. SAW element according to any one of claims 13 to 17, wherein a plurality of encoding channels comprise transducers emitting on one side and on the emitting side transducers are arranged in code-specific distances.

## Revendications

1. Procédé pour effectuer une interrogation à distance sans contact dans un système comportant un groupe de transpondeurs mobiles, selon lequel un poste d'interrogation (1) émet un signal d'interrogation (Q), ce signal d'interrogation est converti dans l'un des transpondeurs (2) comportant un élément SAW (18) en un signal de réponse portant une information et est renvoyé ensuite au poste d'interrogation (1), **caractérisé en ce que** l'élément SAW

    a) produit, pour l'obtention d'un codage de position, un nombre prédéterminé de composantes de signal de réponse d'identification avec un retard de temps de propagation (ou des décalages de fréquences) spécifique à un code, de telle sorte que dans chacune de $N_{ZF}$ fenêtres temporelles (ou fenêtres de fréquences), précisément l'un des $N_{ZF}$ fenêtres temporelles (ou fenêtres de fréquences) contient une composante de signal de réponse, et
    b) ajoute au signal de réponse, pour la mise en oeuvre d'un calibrage ou d'une mesure, une composante de signal de réponse possédant une position prédéterminée de façon fixe à l'intérieur d'une fenêtre temporelle (ou d'une fenêtre de fréquences) définie par avance.

2. Procédé selon la revendication 1, selon lequel l'élément SAW produit de façon précise une composante de signal de réponse pour le calibrage, et selon lequel cette composante de signal de réponse est de préférence la composante de signal de réponse possédant le temps de propagation le plus bref et est séparée par rapport aux composantes de fréquence du signal de réponse d'identification, par un créneau temporel de blocage d'une durée prédéterminée.

3. Procédé selon l'une des revendications 1 à 2, selon lequel

    a) le poste d'interrogation utilise un signal de compression-expansion pour l'interrogation du transpondeur,
    b) le signal de réponse est mémorisé en tant que signal temporel tramé et mémorisé,
    c) pour le décodage de l'information d'identification, le signal temporel mémorisé est soumis à une transformation de Fourier discrète (FFT).

4. Procédé selon l'une des revendications 1 à 3, selon lequel pour la mise en oeuvre du calibrage

    a) le signal de réponse est pondéré par une fonction fenêtre et ensuite est soumis à une transformation de Fourier discrète, et
    b) dans le spectre résultant, une position réelle de la composante du signal de réponse de calibrage est déterminée et est comparée à une position de consigne prédéterminée.

5. Procédé selon la revendication 4, selon lequel

    a) le signal de réponse mémorisé est multiplié par une fonction ($f(t) = e^{-j\Delta\omega t}$) et est mémorisé en tant que signal de temps calibré, $\Delta\omega$ étant un décalage de fréquence déterminé à partir de la comparaison de la position réelle et de la position de consigne de la composante du signal de réponse réalisant le calibrage,
    b) le résultat de la multiplication est pondéré par une fonction fenêtre appropriée et est soumise à une transformation de Fourier discrète,
    c) dans le spectre obtenu, les maxima des valeurs d'appui sont déterminés au moins dans plusieurs ou dans la totalité des fenêtres de fréquences et ensuite un test est effectué pour déterminer si les valeurs d'appui maximales obtenues possèdent un rapport signal/bruit suffisant avant que le code correspondant soit déterminé.

6. Procédé selon l'une des revendications 1 à 5, selon lequel les composantes de signal de réponse réalisant l'identification sont évaluées successivement selon des blocs, un décalage de temps de propagation ou de fréquence, conditionné par la température, étant compensé bloc par bloc.

7. Procédé selon la revendication 6, selon lequel

    a) avant la détermination du code contenu dans la composante de signal de réponse produisant l'identification, une correction supplémentaire, effectuée uniquement par calcul, est réalisée dans une multiplicité de fenêtres de fréquences, un décalage de fréquence $\delta\Delta\omega$, conditionné par la température, étant déterminée à partir du spectre du signal temporel calibré, par corrélation des positions de toutes les valeurs d'appui suffisamment proches de la valeur d'appui de calibrage, à leurs positions de consigne,

b) ensuite le signal temporel mémorisé et calibré est multiplié par une fonction $f(t) = e^{-j\delta\Delta\omega t}$, est pondéré de façon appropriée par une fonction fenêtre et est soumis à une transformation de Fourier,

c) les valeurs d'appui maximales sont déterminées dans le spectre résultant, dans les fenêtres de fréquences non encore décodées,

d) un test desdites valeurs d'appui est effectué pour déterminer si elles présentent un rapport signal/bruit suffisant avant que la partie, qui y est associée, du code soit déterminée.

8. Procédé selon l'une des revendications 1 à 7, selon lequel l'élément SAW produit au moins deux composantes de signal de réponse pour la mesure de la température sur le lieu du transpondeur (2), et des valeurs caractéristiques correspondantes du transpondeur pouvant être identifiées au moyen de son code sont mémorisées dans le poste d'interrogation.

9. Procédé selon la revendication 8, selon lequel pour mesurer la température, on détermine une variation relative du temps de propagation ou de la phase d'au moins deux composantes de mesure du signal de réponse et en outre on détermine ensuite la température à l'emplacement du transpondeur avec une valeur caractéristique ou une valeur de calibrage mémorisée dans le poste d'interrogation et spécifique au transpondeur.

10. Système pour la mise en oeuvre du procédé selon l'une des revendications 1 à 9, comportant:

a) au moins un poste d'interrogation (1) pour émettre un signal d'interrogation (Q) et évaluer des signaux de réponse,

b) un groupe de transpondeurs mobiles comportant chacun au moins un élément SAW (18) pour convertir le signal d'interrogation en un signal de réponse portant une information,

**caractérisé en ce que** l'élément SAW

b1) est agencé pour l'obtention d'un codage de position de telle sorte qu'un nombre prédéterminé de composantes de signal de réponse réalisant une identification est produit avec des retards de temps de propagation (ou des décalages de fréquence) spécifiques au code de telle sorte que dans chacune de $N_{ZF}$ fenêtres temporelles (ou fenêtres de fréquences), précisément l'une de $N_{ZS}$ fenêtres temporelles (ou fenêtres de fréquences) contient une composante du signal de réponse, et

b2) comporte, pour l'exécution d'un calibrage, un canal de calibrage et/ou pour la mesure, au moins deux canaux de mesure de telle sorte qu'une composante du signal de réponse possédant une position prédéterminée de façon fixe à l'intérieur du fenêtre temporelle (une fenêtre de fréquences) définie par avance, peut être ajoutée au signal de réponse.

11. Transpondeur pour la mise en oeuvre du procédé selon l'une des revendications 1 à 9, **caractérisé par** un élément SAW qui

a) produit, pour l'obtention d'un codage de position, un nombre prédéterminé de composantes de signal de réponse identifiant un nombre prédéterminé de composantes de signal de réponse d'identification avec un retard de temps de propagation (ou des décalages de fréquences) spécifique à un code, de telle sorte que dans chacune de $N_{ZF}$ fenêtres temporelles (ou fenêtres de fréquences), précisément l'un des $N_{ZS}$ fenêtres temporelles (ou fenêtres de fréquences contient une composante de signal de réponse, et

b) ajoute au signal de réponse, pour la mise en oeuvre d'un calibrage ou d'une mesure, une composante de signal de réponse possédant une position prédéterminée de façon fixe à l'intérieur d'une fenêtre temporelle (ou d'une fenêtre de fréquence définie par avance) et qui contient, en dehors d'au moins une unité de codage pour l'obtention d'un codage de position, également une unité de calibrage et de mesure pour l'exécution d'un calibrage ou d'une mesure, de sorte que des composantes du signal de réponse, exécutant un calibrage ou une mesure peuvent être produites.

12. Transpondeur selon la revendication 11, comportant en outre une unité de calibrage (12) pour produire de façon précise à un signal de réponse réalisant un calibrage et qui est utilisée notamment pour corriger des influences parasites globales, à savoir des variations du retard de base $T_0$.

13. Elément SAW pour un transpondeur selon la revendication 11 ou 12, **caractérisé en ce qu'**il

a) produit, pour l'obtention d'un codage de position, un nombre prédéterminé de composantes de signal de réponse identifiant un nombre prédéterminé de composantes de signal de réponse d'identification avec un retard de temps de propagation (ou des décalages de fréquences) spécifique à un code, de telle sorte que dans chacune de $N_{ZF}$ fenêtres temporelles (ou fenêtres de fréquences), précisément l'une des $N_{ZS}$ fenêtres temporelles (ou fenêtres de fréquences) contient une composante de signal de réponse, et

b) ajoute au signal de réponse, pour la mise en oeuvre d'un calibrage ou d'une mesure, une composante de signal de réponse possédant une position prédéterminée de façon fixe à l'intérieur d'une fenêtre temporelle (ou d'une fenêtre de fréquences définie par avance), et comporte une unité de codage comportant plusieurs canaux de codage parallèles pour l'obtention d'un codage de position et un canal de calibrage et/ou de mesure pour l'exécution d'un calibrage ou d'une mesure.

14. Elément SAW selon la revendication 13, dans lequel il est prévu une section séparée de retardement, qui augmente le temps de propagation et est commune à plusieurs canaux de codage et qui est couplé audit canaux de codage et au choix au canal de calibrage.

15. Elément SAW selon la revendication 14, dans lequel les canaux acoustiques sont couplés par des électrodes de transducteurs, des réflecteurs à 90° ou une structure RMSC.

16. Elément SAW selon l'une des revendications 13 à 15, dans lequel le canal de calibrage est en chevauchement partiel avec un canal de codage, un réflecteur partiellement transparent étant prévu pour la production des composantes de signal de réponse réalisant le calibrage et par exemple moins retardé.

17. Elément SAW selon l'une des revendications 13 à 16, dans lequel plusieurs canaux de codage sont équipés de transducteurs qui rayonnent des deux côtés et sont disposés des deux côtés et dans lequel des réflecteurs sont disposés des deux côtés desdits transducteurs à des distances spécifiques à un code.

18. Elément SAW selon l'une des revendications 13 à 17, dans lequel plusieurs canaux de codage sont équipés de transducteurs qui rayonnent unilatéralement et dans lequel les transducteurs sont disposés à des distances spécifiques à un code, sur le côté de rayonnement.

Fig. 1

# Fig. 2a

# Fig. 2b

# Fig. 3

**Column 1:**

| Antwortsignal speichern (Zeitsignal) |

↓

| Gewichtung mit Fensterfunktion |

↓

| FFT des Zeitsignals --> Spektrum |

↓

| Suchen der Position des kalibrierenden Stützwertes im Spektrum --> $\Lambda\omega$ |

↓

| Multiplikation des Zeitsignals mit $\exp(-j\Lambda\omega t)$ --> kalibriertes Zeitsignal |

↓

| Gewichtung mit Fensterfunktion |

↓

| FFT des kalibrierten Zeitsignals |

↓

| Suche der lokalen maximalen Stützwerte innerhalb von jedem Frequenzfenster bis max. k Frequenzschlitze. |

**Column 2:**

| Bestimmung des Geräuschwertes N |

↓

Signal/N>= Schwelle → nein → | Fehler |

↓ ja

| Code Teil 1 speichern |

↓

| Schätzung des Gradienten der Temperaturverschiebung im Code Teil 1 |

↓

| Bestimmung der Frequenzverschiebung des letzten (k.) Frequenzfensters von Code Teil 1 --> $\delta\Delta\omega$ |

↓

| Multiplikation des kalibrierten Zeitsignals mit $\exp(-j\delta\Delta\omega t)$ |

↓

| Gewichtung mit Fensterfunktion |

**Column 3:**

| FFT des korrigierten und kalibrierten Zeitsignals |

↓

| Suche der lokalen maximalen Stützwerte innerhalb von jedem Frequenzfenster oberhalb Code Teil 1bis max. 2 k Frequenzschlitze. |

↓

Signal/N>= Schwelle → nein → | Fehler |

↓ ja

| Code Teil 2 speichern |

⋮

etc.

EP 0 939 907 B1

Fig. 4

# Fig. 5

EP 0 939 907 B1

# Fig. 6a

# Fig. 6b

EP 0 939 907 B1

# Fig 6c

33.1

32

31.1

31.2

33.2

# Fig 6d

34

35.1

32

31.1

31.2

35.2

EP 0 939 907 B1